# EUROPEAN PATENT SPECIFICATION

(11) **EP 0 608 418 B1**
(45) Date of publication and mention of the grant of the patent: **04.11.1998**
(21) Application number: 92910593.0
(22) Date of filing: 20.05.1992
(51) Int. Cl.: G06K 19/00, G06K 19/077

(54) **CARTRIDGE FOR ELECTRONIC APPARATUS**
KASSETTE FÜR EINE ELEKTRONISCHE VORRICHTUNG
CARTOUCHE DESTINEE A UN APPAREIL ELECTRONIQUE

(43) Date of publication of application: 03.08.1994
(73) Proprietor: SEIKO EPSON CORPORATION, Shinjuku-ku Tokyo 160 (JP)
(72) Inventor: WAKABAYASHI, Ken-ichi, Suwa-shi, Nagano-ken 392 (JP); TAKAYAMA, Chitoshi, Suwa-shi Nagano-ken 392 (JP); Shiozaki, Tadashi, Suwa-shi, Nagano-ken 392 (JP)
(74) Representative: Hoffmann, Eckart, Dipl.-Ing.
(86) International application number: PCT/JP92/00649
(87) International publication number: WO 93/23825

(56) References cited:
- FR-A- 2 601 791
- GB-A- 2 248 973
- JP-A- 2 277 700
- JP-A-54 002 834
- JP-A-60 173 791
- PATENT ABSTRACTS OF JAPAN vol. 14, no. 128 (P-1019) 9 March 1990 & JP-A-01 319 194 (NEC CORP) 25 December 1989

## Description

### FIELD OF THE INVENTION

The present invention relates to cartridges for electronic devices that are inserted in printers and other types of electronic devices.

### BACKGROUND OF THE INVENTION

In recent years, personal computers, word processors, workstations and other electronic devices founded on digital operation, and printers, facsimile machines, electronic pocketbooks, electronic musical instruments, electronic cooking appliances, electronic cameras and other electronic devices containing microprocessors are being used in all areas of society. Further, the use of microprocessors is spreading to automobiles, robots and machine tools, as well as all types of electric products.

Devices founded on this type of digital logic operation have the potential of flexible control as compared with simple feedback control realized with hardware only, and they also have the advantage of being able to change essential functions by changing the software. Therefore, it is possible to realize completely different control within the same hardware by just changing the contents of the ROM where procedures are stored. Another advantage is the ability to upgrade functions by just changing the software.

However, since the throughput of the processor that actually performs control is dependent on the hardware, i.e., number of operations per unit time, number of bits that can be handled at one time and width of the bus that performs data transfer, improvement by upgrading the software is limited to only improved usability, and any significant improvement in the performance of the existing electronic device cannot realistically be achieved. Further, upgrading by changing the software is often difficult because the software is often burned into the ROM and the ROM must be replaced to change the software. Therefore, upgrading the software is difficult except in cases in which ROM replacement is designed into the device from the beginning or the software is supplied on a replaceable medium such as a floppy disk.

In personal computers, for example, accelerators are used which improve the functionality of the entire computer by completely replacing the microprocessor, but this requires replacement of the CPU on the motherboard or other difficult operations that cannot by performed by just anyone. Normally, no consideration has been made regarding the improvement or changing of the functionality of printers, facsimile machines, electronic pocketbooks, electronic musical instruments, electronic cooking appliances, electronic cameras and other consumer electronics containing a microprocessor, electrical equipment for automobiles, robots, machine tools and other industrial electronic apparatus, and all types of electric appliances. This problem is described in detail below using a page printer as an example.

In recent years, the diffusion of laser printers and other page printers has become extremely widespread, and high speed output devices for data from computers have become common. In the case of laser printers, their resolutions range from 240 to 800 dots per inch (DPI), and printers capable of printing several pages a minute are being developed. These printers employ a xerography unit that uses a photosensitive drum as the engine for printing, and since they continuously perform each of the charging, exposure, toner application and transfer processes in sync with the rotation of the photosensitive drum, printing processing begins after the image for a single page is stored in memory.

Therefore, the memory provided in page printers for image development must have the capacity to hold the image for at least one page, and if compression of image data is not performed, the capacity is determined by the resolution and the size of the paper that can be processed. For example, in the case of a resolution of 300 DPI and a paper size of 8 inches by 10 inches, 7,200,000 (8 x 10 x 300 x 300) dots must be manipulated and at least a 0.9-megabyte memory is required.

Also, if the print data received from the external computer is a bit image of the image to be printed, then the printer need only perform processing that receives the data and sequentially stores it in memory, and the processing speed is mainly dependent on the speed with which the data are transferred. Since parallel transfer, e.g., transfer based on the Centronics standard, is considerably fast, transfer speed will not likely be slower than the printing capacity of the xerography unit.

However, in printers with a function that receives character codes, row and column pitch and other information as print data and expands this into the image, or in printers that receive a program described by a page description language and expand the image by interpreting it, it is necessary to calculate and produce a bit image based on this print data, which greatly reduces the overall processing speed compared to simple bit image transfer. That is, the processing speed of a printer is determined mainly by the throughput of the processor that performs processing and memory access time and falls far short of the printing throughput of the xerography unit itself.

For example, in a page printer capable of printing 10 pages in one minute, only six seconds is allowed to prepare the image data for one page of printing, and to develop all of this 0.9 megabytes of data in this period of time means that the processing time allowed for one byte is a mere 6.6 microseconds (6 s/0.9 MB). This processing speed can possibly be realized by one of the high speed RISC type processors currently available on the market. In contrast to this, there are currently many xerography units capable of printing 10 pages per minute. Therefore, the throughput of the controllers that process print data has become a bottleneck in improving overall print speeds.

There are some page printers whose functionality can be improved by being able to increase internal memory capacity or by providing an expansion slot and installing a cartridge with built-in fonts or programs in it, but attempts to improve processing speed through memory expansion do not improve throughput. For example, to expand the functionality of a laser printer that supports only a specific page description language to process another page description language, the program of the other page description language interpreter is supplied in the form of an IC card or other type of cartridge. This cartridge contains the program in the form of a mask ROM and is installed in the expansion slot of the printer.

Below is an explanation of this cartridge which supplies the program of the page description language interpreter. The controller of the printer itself reads a prescribed address assigned to the cartridge according to a certain timing, such as immediately after powering on. If the cartridge which contains the page description language program has been installed, a specific code is returned, whereby the controller knows that the cartridge is the page description language. By this means, control of the printer is transferred to the interpreter program in the cartridge. As a result, the printer becomes capable of interpreting data received from outside it according to this page description language, but processing speed itself is not improved, and in fact the overall printing speed may even be reduced by employing a new high level page description language.

Therefore, to solve the above problems, we have invented a cartridge equipped with a microprocessor separate from the main printer unit. This cartridge has a function to receive print data from the main printer unit, and the microprocessor in the cartridge has a function to develop image data based on the received print data.

The above cartridge has a case made from aluminum, whereby the heat generated in the microprocessor is radiated, but this kind of metal case becomes an antenna that increases the amount of unnecessary electromagnetic radiation, thus causing noise in the cartridge itself or in the electronic device surrounding it and resulting in misoperation or other malfunctions.

There are also problems that must be resolved regarding the heat radiation characteristic of the cartridge. The microprocessor used in the above cartridge is an electronic circuit with several ten thousand to several hundred thousand elements, and these elements perform switching operations according to a clock signal with a frequency from 20 to 40 MHz or even higher. Therefore, the microprocessor generates considerable heat during operation. For this reason, if the heat generated by the microprocessor is not dissipated to the outside, the temperature of the microprocessor will rise, which will cause the microprocessor to malfunction or damage to the internal elements.

In order to prevent malfunction or damage to the elements, the maximum allowable temperature of the microprocessor with respect to the case is set at about 80° C. In order to maintain the surface temperature of the case below the allowable temperature, it is important that the structure of the cartridge be designed such that heat can be easily radiated from the microprocessor to the outside.

A cartridge according to the precharacterizing portion of claim 1 is disclosed in FR-A-2 601 791. The known cartridge has a grounding plate bent around the front edge of an upper housing part above a connector. The grounding plate is connected with the wiring on a circuit board inside the housing and with a magnetic sielding plate provided on the inner surface of the upper housing part.

GB-A-2 248 973 discloses a memory cartridge having a conductive housing and connection means for connecting the conductive housing to a ground terminal of the cartridge's connector.

The invention is intended to solve the above problems in the prior art, and its main purpose is to offer a cartridge for electronic devices in which a microprocessor and other circuit elements are built in that execute prescribed processing based on data received from the electronic device and which reduces unnecessary electromagnetic radiation to the outside.

An additional purpose of the invention is to offer a cartridge for electronic devices which is capable of efficiently cooling internal circuit elements.

The object of the invention is achieved with a cartriidge as claimed in claim 1. Preferred embodiments are subject-matter of the dependent claims.

In order to solve the above problems, the cartridge for electronic devices of the invention is a cartridge for electronic devices that is inserted in a prescribed insertion opening of an electronic device equipped with a first processor capable of logic operation, and it is equipped with a conductive shielding member and a connection means that electrically connects the shielding member and a conductive member of the electronic device. By equipping this cartridge with a conductive shielding member, the radiation of electromagnetic noise to the outside is prevented.

This cartridge is further equipped with a second processor and a circuit board on which the second processor is mounted, and the connection means may be equipped with a means that electrically connects the shielding member, the power source wiring on the circuit board, and a conductive member of the electronic device. Since the connection means electrically connects the shielding member, the power source wiring and a conductive member of the electronic device, the potential difference of the shielding member is stabilized, whereby the generation of electromagnetic noise is prevented.

Further, a case may be used to house the circuit board, and the case may include the shielding member. At least part of this case may be metal, or at least part of it may have a conductive layer.

It is desirable that the case have first and second case elements which are mated and house the circuit board, and that at least the part of the cartridge protruding from the electronic device when the cartridge is installed in the electronic device have conductive layers formed on the mating surfaces of each of the first and second case elements. In this cartridge, the case is formed by mating the first and second case elements, and by forming a conductive layer on each of the mating surfaces of the first and second case elements, the radiation of electromagnetic noise from the mated part of the two case elements is prevented.

In one embodiment of the invention, one of the first and second case elements is made of plastic, and the other is made of metal.

The connection means should electrically connect the power source wiring on the circuit board to the shielding member at multiple locations. This configuration reduces the impedance between the power source wiring on the circuit board and the shielding member, and therefore it is effective in preventing the generation of high frequency noise.

If the case should have a through-hole, the connection means should have a means for electrically connecting the power source wiring on the circuit board and the shielding member at at least one location between the two ends of the through-hole. Since the wavelength of the electromagnetic radiation emitted to the outside from the through-hole can be shortened in this configuration, it effectively reduces harmful electromagnetic noise.

The connection means may be equipped with a conductive elastic member secured to the shielding member, and the conductive elastic member may have a protruding member that protrudes to the outside from an opening in the case and also electrically connects to a conductive member of the electronic device when the cartridge is inserted in the electronic device.

Also, the connection means may be equipped with multiple conductive elastic members so that at least one conductive elastic member electrically connects to a conductive member of the electronic device when the cartridge is inserted in the electronic device.

Further, the multiple conductive elastic members may electrically connect the shielding member and the power source wiring on the circuit board.

With respect to the heat dissipation characteristic, a metal heat dissipation member secured to the metal case element and disposed inside the case such that it opposes the top surface of the second processor and an intervening member that is disposed between the heat dissipation member and the top surface of the second processor and is in contact with the heat dissipation member and the second processor should be provided. By this means, the heat generated by the second processor can be dissipated to the outside via the heat dissipation member and the metal case element.

Further, by providing an elastic member for pushing the second processor toward the heat dissipation member, the thermal resistance between the second processor, the intervening member and the heat dissipation member can be reduced.

By providing the circuit board with a connector for expansion memory, memory can be easily added as required depending on the application of the cartridge.

In this case, an expansion slot for inserting the expansion memory in the connector for expansion memory and a removable expansion slot cover should be provided in the case, and the expansion slot cover should be disposed in a position that is hidden inside the electronic device when the cartridge is inserted in the electronic device. This will prevent inadvertent removal or insertion of the expansion memory while the cartridge is in use.

By configuring the expansion memory as an IC card, memory expansion is simplified.

By providing the cartridge for electronic devices with a joining means that mechanically joins the cartridge for electronic devices and the main electronic device unit, theft of the cartridge for electronic devices can be prevented. Further, the joining means may be provided with a locking means and a switching means that switches on the power source of the cartridge for electronic devices when the locking means is locked.

Another configuration of the cartridge for electronic devices of the invention is a cartridge for electronic devices that is inserted in an electronic device via a prescribed insertion opening, and it is has a circuit board on which is mounted a digital processor, a case with a shielding member made from a conductive material and that houses the circuit board, and a grounding means that electrically connects a conductive member of the electronic device, the power source wiring on the circuit board and the shielding member.

Another configuration of the cartridge for electronic devices of the invention is a cartridge for electronic devices that is inserted via a prescribed insertion opening in an electronic device which is equipped with a first processor capable of logic operation and a connector connected to at least the address signal line of the first processor, it is has a data fetch means that fetches data reflected in the address from the address signal output from the electronic device, a case having a conductive shielding member and that houses the second processor, and a connection means that electrically connects a conductive member of the electronic device, the power source wiring on the circuit board and the shielding member.

Another configuration of the cartridge for electronic devices of the invention is a cartridge for electronic devices that is inserted via a prescribed insertion opening in an electronic device which is equipped with a first processor capable of logic operation, a first memory means that stores the processing executed by the processor, a connector connected to at least the address signal line of the first processor and an address output means that reflects the data to be transferred to the outside in an address signal and outputs the address signal via the connector, it is has a second processor, a second memory means that stores the procedures executed by the second processor, a data fetch means that fetches data reflected in the address from the address signal output from the electronic device, a circuit board on which are mounted the second processor, the second memory means and the data fetch means, a case having a conductive shielding member and that houses the circuit board, and a grounding means that electrically connects a conductive member of the electronic device, the power source wiring on the circuit board and the shielding member.

The invention also includes electronic systems configured by combining each of the cartridges for electronic devices described above and electronic devices.

### BRIEF DESCRIPTION OF THE DRAWINGS

- FIG. 1: is a perspective view showing a cartridge as one embodiment of the invention;
- FIG. 2: is an exploded perspective view of the cartridge of the embodiment;
- FIG. 3: is a perspective view showing the printed circuit board enlarged;
- FIG. 4: is a diagram showing the lower case;
- FIG. 5: is a plan view showing the printed circuit board;
- FIG. 6: is a side view showing the printed circuit board mounted in the lower case;
- FIG. 7: is a cross-sectional view showing an enlargement of the principal parts around the microprocessor of the cartridge;
- FIG. 8: is a perspective view showing the cartridge inserted in a first type main printer unit;
- FIG. 9: is a perspective view showing the cartridge inserted in a second type main printer unit;
- FIG. 10: is a longitudinal sectional view of the cartridge inserted in the first type main printer unit and the main printer unit;
- FIG. 11: is a longitudinal sectional view of the cartridge inserted in the second type main printer unit and the main printer unit;
- FIG. 12: is a graph showing the results of measurements of electromagnetic noise before and after electromagnetic noise countermeasures were taken;
- FIG. 13: is a conceptual diagram showing the cartridge joined to the main printer unit with a chain;
- FIG. 14: is a conceptual diagram showing the cartridge with a keyed lock mechanism;
- FIG. 15: is a block diagram showing the overall configuration of the printer and the cartridge;
- FIG. 16: is an explanatory diagram showing the configuration of the signal lines in the connector CN11;
- FIG. 17: is an explanatory diagram showing the address map of the cartridge 503 as seen from the electronic control device 501;
- FIG. 18: is an explanatory diagram showing the address map of the cartridge 503 as seen from the microprocessor 601;
- FIG. 19: is a block diagram showing the internal configuration of the cartridge 503;
- FIG. 20: is a circuit diagram showing example configurations of the interrupt request registers 640;
- FIG. 21: is a circuit diagram showing an example configuration of the polling command register;
- FIG. 22: is an explanatory diagram showing the contents of the status registers 645;
- FIG. 23: is a circuit diagram showing an example configuration of the read control circuit 620;
- FIG. 24: is a flowchart of the processing performed by the electronic control device 501 for realizing data transfer using the read control circuit 620;
- FIG. 25: is an explanatory diagram showing the configuration of data in ROM 671;
- FIG. 26: is a flowchart of the processing performed by the cartridge 503 for realizing data transfer using the read control circuit 620;
- FIG. 27: is a flowchart showing the processing performed by the electronic control device 501 for realizing data transfer using the FIFO control circuit 623;
- FIG. 28: is a flow chart showing the processing performed by the cartridge 503 for realizing data transfer using the FIFO control circuit 623;
- FIG. 29: is a circuit diagram showing an example configuration of the double-bank control circuit 624;
- FIG. 30: is a flowchart of the processing for beginning data transfer using the double-bank control circuit 624;
- FIG. 31: is a flowchart of the response processing executed in the electronic control device 501 of same;
- FIG. 32: is a flowchart of the processing executed in the electronic control device 501 for realizing data transfer using the double-bank control circuit 624;
- FIG. 33: is a flowchart of the processing executed in the cartridge 503 for realizing data transfer using the double-bank control circuit 624; and
- FIG. 34: is a timing chart showing the timing for the printing of image data performed by controlling the laser engine 505.

### EXPLANATION OF NUMBERS IN FIGURES

- 1, 1a, 1b: main printer unit
- 15: xerography unit
- 34: data bus
- 36: bus driver
- 50: cartridge
- 56: ROM
- 68: data selector
- 100: upper case
- 102: silicon rubber for dissipating heat
- 104: spring member for grounding
- 106: slot for expansion memory
- 108: end
- 110: metal plate
- 120: lower case
- 122: spring member
- 124: mating member
- 126: silicon rubber for applying pressure
- 128: rubber retainer
- 132: opening
- 140: lower cap
- 142: through-hole
- 150: upper cap
- 160: screw
- 180: metal frame
- 182: metal frame
- 200: IC card
- 500: printer
- 501: electronic control device
- 503: cartridge
- 505: laser engine
- 507: workstation
- 510: CPU
- 511: ROM
- 512: RAM
- 514: data input port
- 515: line buffer
- 516: bus line
- 517: register
- 518: console panel
- 519: console panel I/F
- 520: double-buffer circuit
- 550: printed circuit board
- 551: plug
- 601: microprocessor
- 602: memory
- 603: ASIC
- 603: data transfer controller
- 606: ROM
- 608: ROM
- 610: selector
- 610: data selector
- 611: RAM
- 615: expansion RAM interface
- 617: tristate buffer
- 618: ROM
- 619: tristate buffer
- 620: read control circuit
- 621: FIFO memory
- 623: FIFO control circuit
- 624: double-buffer control circuit
- 635: bus controller
- 637: reset terminal
- 640: interrupt request register
- 643: command register
- 645: status register
- 647: transfer flag register
- 649: PROM control register
- 650: control register
- 651: latch
- 653: FIFO register
- 654: FIFO write circuit
- 655: FIFO read register
- 657: latch
- 658: buffer
- 661: oscillator
- 665: oscillator
- 670: EEPROM
- 671: ROM
- 674: D-type flip-flop
- 680: NAND gate
- 681: data selector
- 682: data selector
- 684-686: tristate buffers
- 691: RAM
- 694, 695: OR gates
- 696: inverter
- 520A: RAM
- 520B: RAM
- 520C: memory write controller
- 520D: memory read controller
- 601p: pin
- 640a: flip-flop
- 640a: interrupt request register
- 643a: octal D-type flip-flop
- 643c: D-type flip-flop
- 6521: latch
- 7900: usable gate
- AAB: address bus
- CAB: address bus
- CDB: data bus
- CN10: connector
- CN11: connector

### PREFERRED EMBODIMENTS FOR IMPLEMENTING THE INVENTION

Explanations of the embodiments are divided up into the following items.
[i] Cartridge Structure
   A. Cartridge Structure
   B. Test Results for Electromagnetic Noise
   C. Modifications of Cartridge Structure
[ii] Electrical Configuration of Printer and Cartridge
   A. Overall Configuration of Printer and Cartridge
   B. Address Space of Cartridge
   C. Internal Configuration of Cartridge
   D. Explanation of Data Transfer Controller 603
   E. Explanation of Registers
   F. Configuration and Operation of Read Control Circuit 620
   G. Configuration and Operation of FIFO Control Circuit 623
   H. Configuration and Operation of Double-Bank Control Circuit 624
   I.Printing of Image Data
[iii] Other

### [i] Cartridge Structure

### A. Cartridge Structure

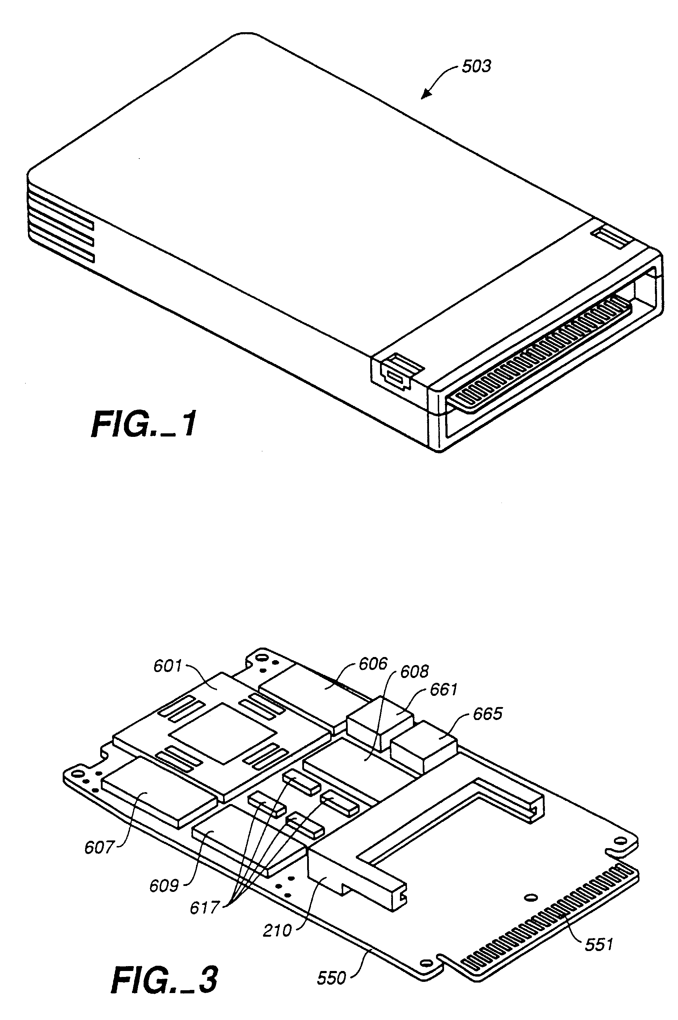

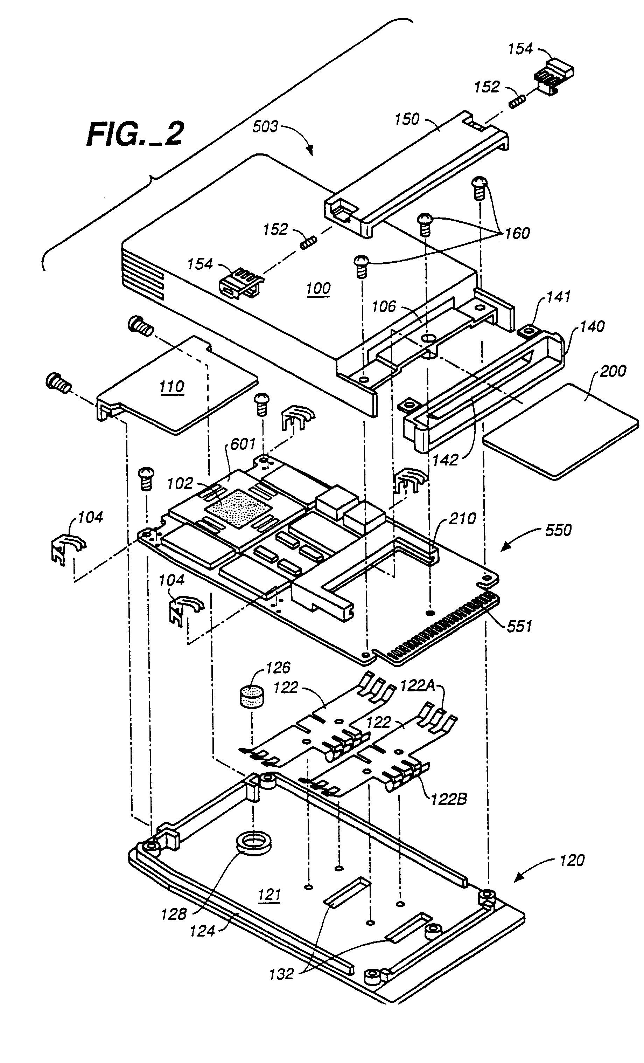

FIG. 1 is a perspective view showing a cartridge for printers as one embodiment of the invention, and FIG. 2 is an exploded perspective view of the same. This cartridge 503 is designed as a cartridge to be inserted in the font cartridge insertion opening of the main printer unit. However, this cartridge has functions to receive print data from the main printer unit and develop the received print data into image data.

The cartridge 503 has a structure in which a multilayer printed circuit board 550 (printed circuit board below) is sandwiched between an upper case 100 recessed on the inside and a plate-like lower case 120 and a lower cap 140 and upper cap 150 are attached to the connector side of the cartridge 503. The upper case 100, lower cap 140 and upper cap 150 are made from ABS resin, and the lower case 120 is made from aluminum. A conductive layer is formed on the inside surface of the upper case 100, which together with the lower case 120 constitutes a frame ground. The conductive layer on the inside surface of the upper case 100 is formed from electroless copper-nickel plating. This conductive layer can also be formed by applying a conductive coating, by vacuum deposition of aluminum or other known method. Also, the upper case 100 can be made by forming conductive plastic.

Below, the side with the caps 140 and 150 is referred to as the front of the cartridge and the side with the microprocessor 601 is referred to as the rear of the cartridge.

The plug 551 is formed on the front of the printed circuit board 550, and the microprocessor 601 and other circuit elements are attached toward the rear. Four spring members 104 for grounding are secured to the outer edge of the printed circuit board 550, two of which are disposed in the center in the direction of insertion and the other two are disposed at the rear of the cartridge. The spring members 104 perform the role of electrically connecting the ground wiring on the printed circuit board 550 and the conductive layer on the inside surface of the upper case 100.

Two spring members 122 for grounding are secured toward the front of the lower case 120 to secure a ground connection with the main printer unit. The spring members 122 for grounding are shaped like a bird with its wings spread, and the first curved members 122a, which correspond to the right and left wings are bent upwards, and the second curved member which corresponds to the bird's feet is bent downward in the shape of a semicircular arc. The first curved members 122a perform the role of electrically connecting the lower case 120 and the ground wiring on the printed circuit board 550. The second curved member protrudes to the outside of the cartridge 503 from the openings 132 in the lower case 120 and perform the role of electrically connecting the grounding member of the main printer unit and the lower case 120.

Around the periphery of the lower case 120 is provided a wall-shaped mating member 124 protruding up from the plate member 121. The mating member 124 mates with the sides of the upper case 100 to form the principal structure of the nearly rectangular case.

At the rear of the lower case 120, a cylindrically shaped silicon rubber 126 for applying pressure, which pushes the printed circuit board 550 up, is fitted in the rubber retainer 128 on the inside of the lower case. The silicon rubber 126 for applying pressure performs the role of pushing up the printed circuit board 550 directly under the microprocessor 601. A silicon rubber sheet 102 for dissipating heat is disposed between the top surface of the microprocessor 601 and the inside surface of the upper case 100 to improve contact and heat conductivity. Also, a heat dissipation plate 110 made from aluminum is secured to the lower case 120 so that it covers the top of the microprocessor 601. When the silicon rubber 126 for applying pressure pushes the printed circuit board 550 up, the microprocessor 601 is also pushed up, which improves the contact between the microprocessor 601 and the silicon rubber 102 for dissipating heat and between the silicon rubber 102 for dissipating heat and the heat dissipation plate 110. As a result, the heat generated by the microprocessor 601 is transmitted to the lower case 120 via the heat dissipation plate 110 and is dissipated to the outside from the lower case 120.

After the two spring members 122 for grounding are secured to the lower case 120 in assembly, the silicon rubber 126 for applying pressure is fitted in the rubber retainer 128. The various circuit elements are attached to the printed circuit board 550 and the four spring members 104 for grounding are inserted in the prescribed holes on the printed circuit board 550 and each is secured in place by soldering. Next, the printed circuit board 550 is placed in the lower case 120, and the rear corners (on the microprocessor 601 side) are secured in place with screws. Also, the heat dissipation plate 110 is secured to the side of the mating member 124 of the lower case 120 with screws. Next, the upper case 100 is mated with the lower case 120, and the lower cap 140 is inserted. At this time, the two through-hole members 141 in the lower cap 140 are inserted under their corresponding members on the upper case 100, and the plug 551 passes through the through-hole 142 of the lower cap 140. The upper case 100 is secured in place at three locations toward the front. Finally, the cartridge 503 is completed as shown in FIG. 1 by fitting the upper cap 150 on the upper case 100.

Button locks 154 containing springs 152 inside are provided on both sides of the upper cap 150. The button locks 154 are pushed to the outside by the springs 152, and when the two button locks 154 are pressed toward the inside, the tabs on the button locks 154 are released from the retainer members on the upper case 100 and when the button locks 154 are released, the tabs engage the retainer members.

FIG. 2 also shows an IC card 200. The IC card 200 is an expansion memory with multiple dynamic RAM and it can be inserted in the cartridge 503 as required. When inserting the IC card 200, first the upper cap 150 must be removed, and then by inserting the IC card 200 in the slot 106 for expansion memory provided in the upper case 100, the IC card 200 is inserted in the connector 210 for IC cards on the printed circuit board 550. Also, when the upper cap 150 is attached, the cartridge 503 is returned to the condition shown in FIG. 1. In this embodiment, the IC card is inserted by removing the removable upper cap 150, thus simplifying memory expansion. Further, by disposing the upper cap 150 at the front of the cartridge 503, the IC card 200 cannot be inserted while the cartridge 503 is inserted in the main laser printer unit.

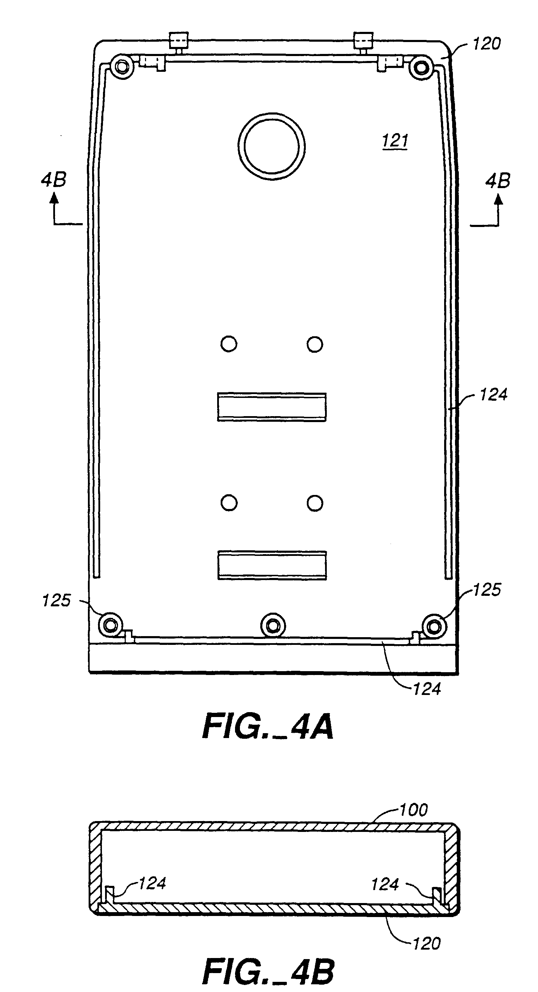

FIG. 3 is a perspective view showing the printed circuit board 550 enlarged. As shown in FIG. 3, the microprocessor 601 is attached toward the rear of the upper surface of the printed circuit board 550, and the insertion plug 551 for connecting to the connector of the main printer unit is formed at the other end.

Around the microprocessor 601 are disposed four ROMs 606 to 609 that store the control program for the microprocessor 601, four address buffers 617 and the clock oscillators 661 and 665. Also, the connector 210 for IC cards is disposed slightly toward the front from the center of the printed circuit board 550. The ASIC (special-application LSI), which includes the control circuits, registers, etc., and the ROM, which store the processing program for the processor in the main printer unit (main printer unit ROM), and other circuit elements are mounted on the under surface of the printed circuit board 550. For convenience sake, the wiring pattern formed on the top surface of the printed circuit board 550 is omitted.

The microprocessor 601 is a pin grid array (PGA) type element, and the other elements are SOJ types, SOP types or QFP types. AMD Corporation's Am29030 RISC processor (25-MHz clock frequency), for example, is used as the microprocessor 601.

As described above, this cartridge 503 is inserted in the font cartridge insertion opening of the main printer unit. Regular font cartridges only house ROM in which font data are stored. In contrast to this, the cartridge 503 of this embodiment is equipped with a microprocessor 601, ROMs 606 to 609 in which the processing program for the microprocessor 601 is stored, a main printer unit ROM and a control circuit, which includes the ASIC.

Since the connector of the main printer unit in which the cartridge 503 is inserted is configured according to specifications for connection of a font cartridge, there are read-only lines for reading data from the cartridge to the main printer unit, but there are no signal lines for transferring data from the main printer unit to the cartridge. However, the cartridge 503 of this embodiment has a function to receive print data from the main printer unit and develop this print data into image data in the microprocessor 601. In this case, it necessary to use the read-only lines of the connector to transfer print data from the main printer unit to the cartridge, and therefore the microprocessor of the main printer unit is made to execute special processing as described below.

When the cartridge 503 is inserted in the main printer unit, the processor in the main printer unit reads the identification data stored in the main printer unit ROM in the cartridge 503, and the processor in the main printer unit performs processing in accordance with the processing program in the main printer unit ROM depending on this identification data.

The processor in the main printer unit executes special processing according to the processing program in the main printer unit ROM. This special processing involves generating an address that essentially includes one byte of print data (page description language program), supplying this address to the address bus and transferring it from the main printer unit to the cartridge 503. The ASIC in the cartridge receives this address and extracts the one byte of print data included in the address by interpreting it and then stores it in the prescribed RAM (described later) in the cartridge. The microprocessor 601 performs processing that develops one page of print data stored in this RAM into image data. In this way, the developed image data are transferred from the cartridge 503 to the main printer unit and the image is printed by the xerography unit.

A processor that is faster than the main printer unit should be used as the microprocessor 601. By this means, the image developing processing that should be executed by the main printer unit is performed by a fast microprocessor 601, and therefore the processing speed of the printer can be essentially increased. The circuitry in the cartridge 503 and its operation are described in greater detail below.

FIG. 4 (A) is a plan view of the lower case 120 and FIG. 4 (B) is a cross section along line B-B. However, the cross section of the upper case 100 is also shown in FIG. 4 (B). As shown in FIG. 4 (A), the lower case 120 comprises mainly the plate member 121 and the mating member 124. The mating member 124 forms a continuous wall around the lower case 120 except around the screw holes 125 at the front in the direction of insertion. As shown in FIG. 4 (B), the mating member 124 mates with the inner surface of the sides of the upper case 100 to form a case with a nearly rectangular cross section. As mentioned above, the lower case 120 is made from aluminum and a conductive layer is formed on the inside surface of the upper case 100. Therefore, on the outside surface of the mating member 124, the conductive layers on the outside surface of the mating member 124 and the inside surface of the upper case 100 overlap each other, which has the effect of blocking electromagnetic noise generated from internal circuit elements.

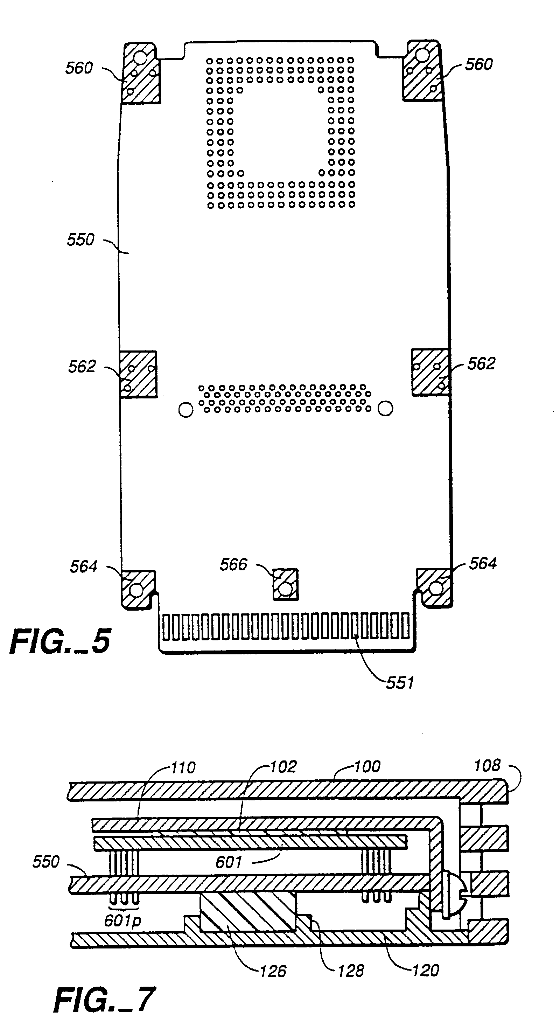

FIG. 5 is a bottom view of the printed circuit board 550 (surface opposite the surface on which the microprocessor 601 is mounted). FIG. 5 shows a condition in which no circuit elements are mounted. Multiple GND lands 560, 526, 564 and 566 are formed around the outside edge of the printed circuit board 550. These GND lands are conductive layer areas provided for use as signal grounds on the printed circuit board 550.

As can be seen from a comparison with FIG. 2, the two GND lands 560 disposed at the rear of the printed circuit board 550 (top of FIG. 5) are formed in areas that include the through-holes for screws which secure the printed circuit board 550 to the lower case 120 and the three holes for inserting the spring members 104 for grounding. The two GND lands 562 disposed nearly in the middle of the printed circuit board 550 in the direction of insertion are formed in areas that include the three holes for insertion of the spring members 104 for grounding. The two GND lands 564 disposed at the front end of the printed circuit board 550 in the direction of insertion and the GND land 566 disposed in the middle between these are formed in areas that include the through-holes for screws which secure the printed circuit board 550 to the lower case 120.

In the assembled condition of the cartridge 503, the GND lands 560 at the rear of the printed circuit board 550 and the GND lands 562 in the middle are electrically connected to the conductive layer on the inside surface of the upper case 100 via the spring members 104 for grounding. At the same time, the GND lands 560 at the rear of the printed circuit board 550 and the GND lands 564 and 566 at the front are electrically connected to the lower case 120 by coming in contact with the screw hole members in the lower case 120. As a result, the ground wiring (signal ground or SG below) of the printed circuit board 550 is connected to the conductive layer (frame ground or FG below) of the case at multiple locations. By grounding the SG and FG at multiple locations in this way, the impedance between the SG and FG can be reduced and the generation of high frequency current prevented. This has the effect of preventing the generation of electromagnetic noise caused by high frequency current.

As can be seen in FIG. 2, since there is no conductive layer at the position of the through-hole 142 in the lower cap 140, electromagnetic noise can easily escape to the outside. As is well known, the standard for electromagnetic noise (VCCI in Japan, FCC in the U.S., etc.) regulates a prescribed frequency range (30 to 1 000 MHz), and if electromagnetic noise in this range can be reduced, harmful electromagnetic noise can be prevented. From this standpoint, the GND land 566 disposed near the middle of the plug 551 (FIG. 5) is provided to reduce harmful electromagnetic noise by approximately halving the wavelength (i.e., approximately doubling the frequency) of the electromagnetic noise emitted from the through-hole 142.

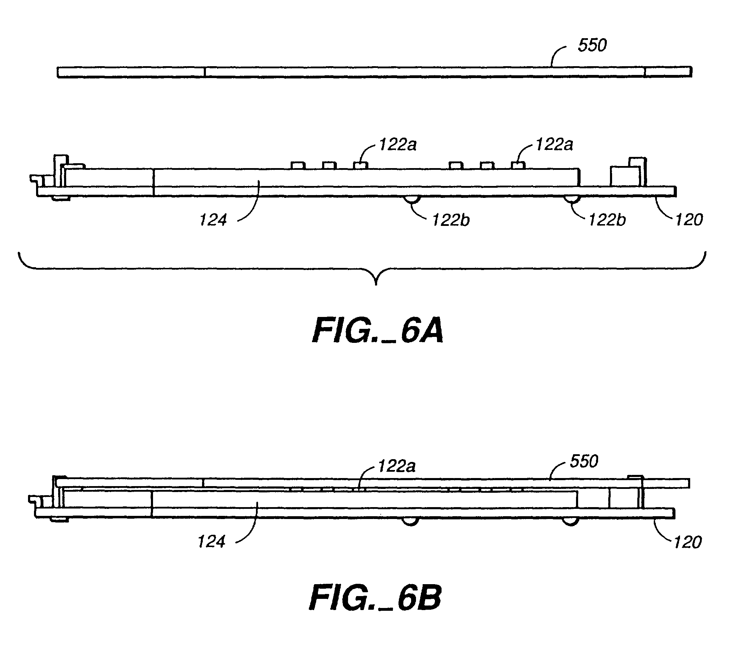

FIG. 6 is a side view for explaining the electrical connection of the printed circuit board 550 and the lower case 120 by the spring member 122 for grounding. FIG. 6 (A) shows the printed circuit board 550 before it is placed on the lower case 120, and FIG. 6 (B) shows it after it is placed on the lower case 120. As shown in FIG. 6 (A), there is a gap between the first curved member 122a of the spring member 122 for grounding and the mating member 124 of the lower case 120. In the condition in FIG. 6 (B), the first curved member 122a presses against the printed circuit board 550, but there is still a small gap between the mating member 124 and the curved member 122a. Since the end of the curved member 122a is divided up into three parts, each of which functions separately as a spring member, the spring member 122 for grounding and the ground wiring on the bottom surface of the printed circuit board 550 are reliably electrically connected. These spring members 122 for grounding also have an effect to prevent the generation of electromagnetic noise.

The first curved member 122a may be connected to power source wiring other than the ground wiring; e.g., it may be used to electrically connect the power source wiring that supplies the stabilized voltage (3 V, 5 V, etc.) for driving the microprocessor 601 and other peripheral circuits and the lower case 120. It may also be connected to the power source wiring for stabilized voltage provided separate from this power source wiring.

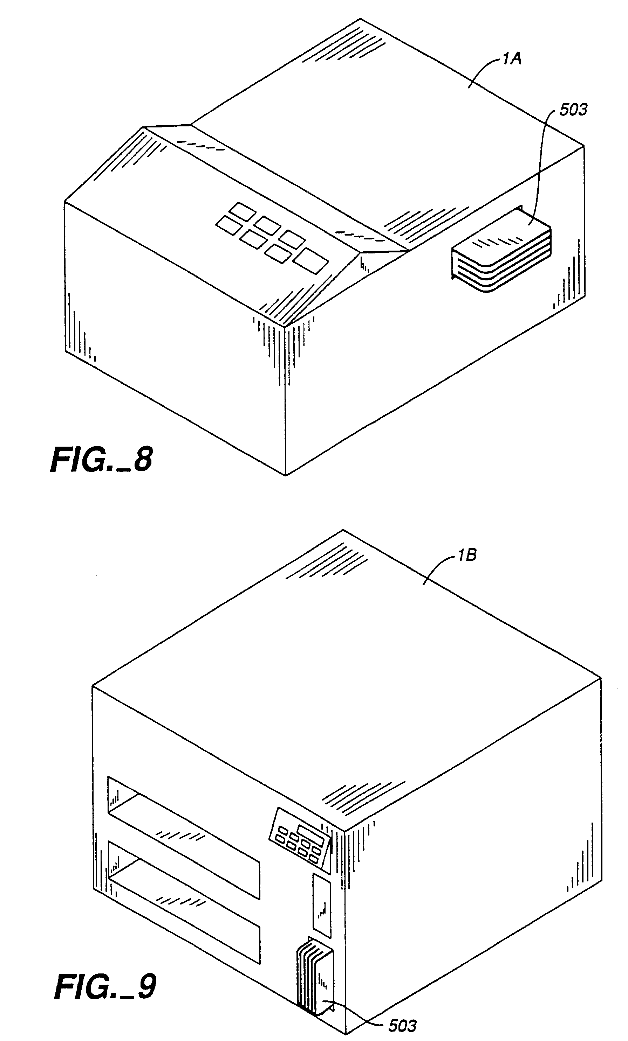

FIG. 7 is a cross-sectional view showing an enlargement of the principal parts around the microprocessor 601 of the cartridge 503. The silicon rubber 126 for applying pressure is fitted in the rubber retainer 128 on the lower case 120, and the silicon rubber 128 for applying pressure pushes the printed circuit board 550 up. The pins 601p of the microprocessor 601 are soldered on the top of the printed circuit board 550. Further, a silicon rubber 102 for dissipating heat is disposed between the top surface of the microprocessor 601 and the heat dissipation plate 110. The heat generated by the microprocessor 601 passes through the silicon rubber 102 for dissipating heat, the heat dissipation plate 110 and the lower case 120, and it is released to the outside from the bottom surface of the lower case 120.

By pushing up the printed circuit board 550 with the silicon rubber 126 for applying pressure, contact between the microprocessor 601, the silicon rubber 102 for dissipating heat and the heat dissipating plate 110 is improved, thus improving heat conduction between them.

Any material with a good coefficient of thermal conductivity can be used as the silicon rubber 102 for dissipating heat. For example, Shinetsu Shiriko sheet (product name) produced by Shinetsu Polymer K.K., TC-CG type silicon rubber sheet (product name) for dissipating heat produced by Shinetsu Kagaku Kogyo K.K. or Sakon (product name) produced by Fuji Kobunshi Kogyo K.K. can be used. All of these have a relatively high coefficient of thermal conductivity that is greater than 1 W/m°K.

Further, a viscous liquid, putty or grease-like nonsolid material that hardens when used such as RTV rubber compound (product name) produced by Shinetsu Kagaku Kogyo K.K. can be used as the material disposed on the top surface of the microprocessor 601. By using a nonsolid material such as this, good contact can be achieved between the microprocessor 601 and the upper case 100 with only a small thickness, and therefore even a material with a relatively low coefficient of thermal conductivity will function well as a material for heat dissipation.

Multiple holes are formed in the end surface 108 of the upper case 100 shown in FIG. 7 to form a structure that allows air to flow easily. These holes are also effective in dissipating heat inside the cartridge 503 to the outside. Opening up multiple holes in the end surface 108 also increases the surface area, which has the effect of improving heat dissipation efficiency. When other heat dissipation measures are sufficient, it is not necessary to open holes in the end surface 108. Further, it is better not to open holes in the end surface 108 when trying to reduce electromagnetic noise.

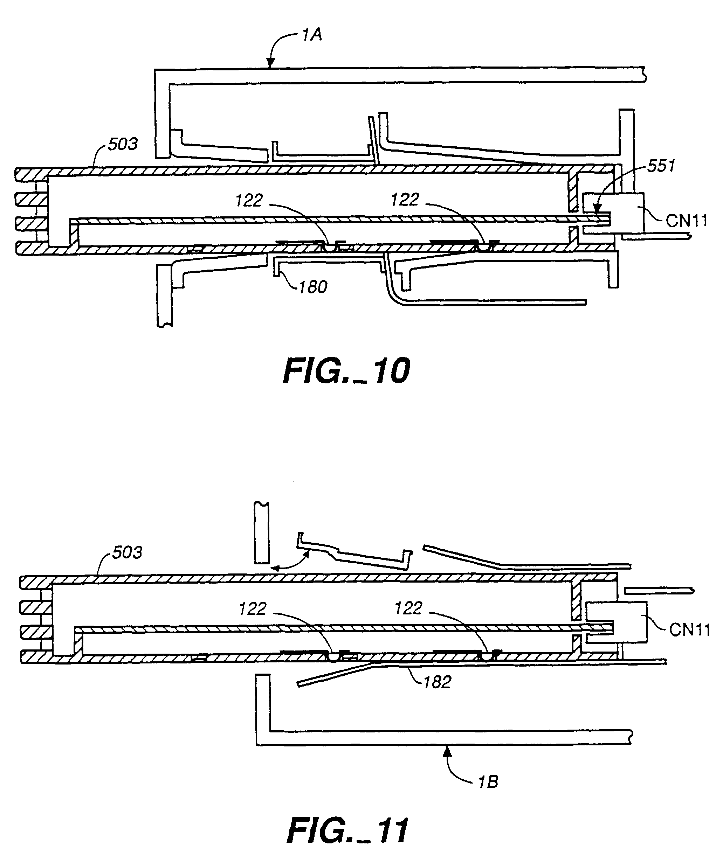

FIGS. 8 and 9 are perspective views showing the first and second types of main printer units 1a and 1b with the cartridge 503 inserted. FIGS. 10 and 11 are longitudinal sectional views of the inserted cartridge 503 and the frames of the main printer units 1a and 1b. However, in FIGS. 10 and 11, the circuit elements, etc., are omitted for convenience sake.

In FIG. 10, the plug 551 of the printed circuit board is inserted in the connector CN11 of the printer. At this time, the spring member 122 toward the rear of the cartridge 503 comes in contact with the metal frame 180 of the main printer unit 1a. In FIG. 11, the spring member 122 toward the front of the cartridge 503 comes in contact with the metal frame 182 of the main printer unit 1. In this way, one of the two spring members 122 for grounding comes in contact with a grounded part of the main printer unit, whereby the cartridge case and the main printer unit are reliably electrically connected.

As described above, the following electromagnetic noise countermeasures have been implemented in the cartridge of this embodiment.
(1) A conductive layer is formed on the inside surface of the plastic upper case 100, and the lower case is made from aluminum. By this means, a conductive layer is formed over the entire inside surface of the case of the cartridge and electromagnetic noise is blocked.
(2) A wall-like mating member 124 is provided around the outside of the lower case 120 such that it fits in the upper case 100. By this means, the conductive layers on the outside surface of the mating member 124 and the inside surface of the upper case 100 overlap and block electromagnetic noise.
(3) The signal ground and frame ground are connected at multiple locations, whereby the impedance between them is decreased and the generation of high frequency current is suppressed.
(4) The signal ground and frame ground are connected at either side and in the middle of the plug 551 near the through-hole 142 for the plug 551, whereby the wavelength of the electromagnetic noise emitted from the through-hole 142 is made smaller (frequency is increased). By this means, electromagnetic noise in the wavelength band that is subject to regulation is reduced.

The following general electromagnetic noise countermeasures are also implemented in this cartridge 503.
(5) A decoupling capacitor is provided near the GND pin of each of the circuit elements and the power source pin.
(6) A common mode choke coil is provided in the power source wiring of the microprocessor 601.

### B.Test Results for Electromagnetic Noise

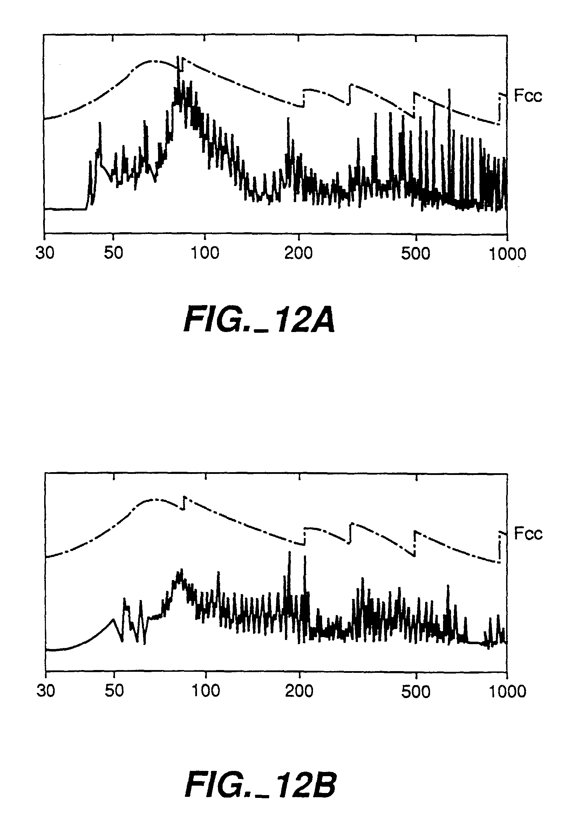

FIG. 12 (A) is a graph showing the results of measurements of the electromagnetic noise of the cartridge before electromagnetic noise countermeasures were taken and FIG. 12 (B) is a graph showing the results of measurements of the electromagnetic noise of the cartridge 503 of an embodiment of the invention. In FIG. 12, the one-dot dashed line indicates the FCC standard. The countermeasures (2) through (6) above were not implemented in the cartridge before countermeasures were taken, and both the upper case 100 and the lower case 120 were made from aluminum. As can be seen in FIG. 12, the above countermeasures reduce electromagnetic noise considerably, and the cartridge after countermeasures are taken sufficiently satisfies the FCC regulation.

### C. Modifications of Cartridge Structure

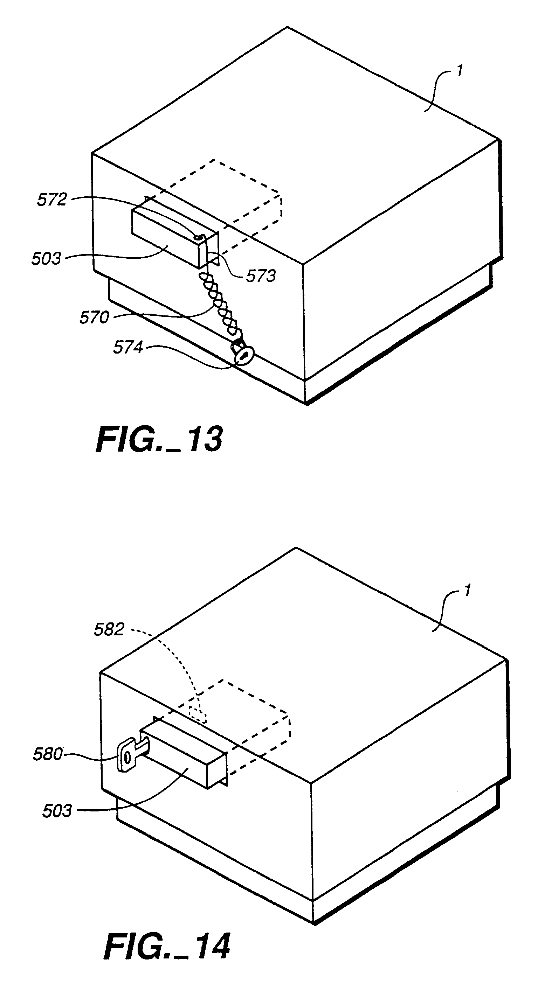

To prevent theft of the cartridge, the cartridge and main printer unit can be mechanically connected. FIG. 13 shows the cartridge 503 and the main printer unit 1 connected by a chain 570. There is a hole 572 in the end of the cartridge 503 and a ring 573 that passes through the hole 572. One end of the chain 570 is attached to the ring, and the other end is secured with a screw to the ground terminal 574 of the main printer unit 1.

FIG. 14 shows a cartridge 503 with a keyed 508 lock mechanism. When the key 508 is turned, a protruding member 582 contained inside the cartridge 503 pops out inside the main printer unit 1 and engages a groove (not shown) in a corresponding position in the main printer unit 1. By this means, the cartridge 503 cannot be pulled out of the main printer unit 1. This key 580 can also be given a switching function. That is, turning the key 580 not only locks the cartridge 503, but it also switches on the power source of the cartridge 503.

Instead of a chain or lock mechanism, the cartridge 503 can also be secured to the main printer unit 1 with a screw to prevent theft.

In the above embodiment, an IC card was used as the expansion memory, but SIMMs (single in-line memory module) or other types of expansion memory can also be used.

### [ii] Electrical Configuration of Printer and Cartridge

### A. Overall Configuration of Printer and Cartridge

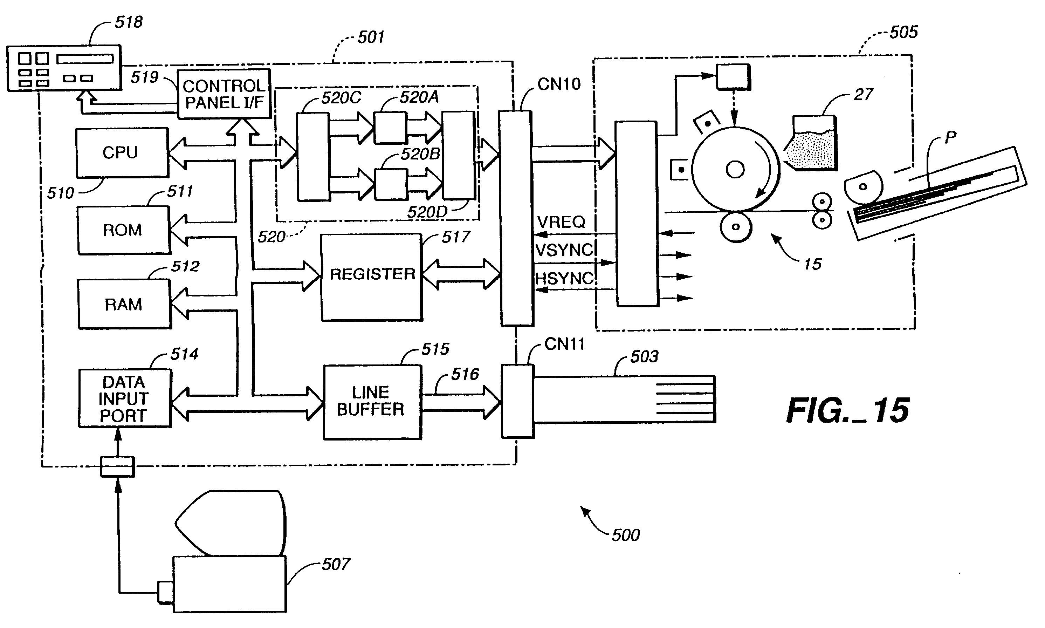

FIG. 15 is a block diagram showing the overall configuration of the laser printer 500 to which the embodiment is applied and the cartridge 503 mounted in it.

The laser printer 500 is equipped with an electronic control device 501 which performs overall control of the laser printer 500 and a laser engine 505 which forms images on the paper P. The laser printer 500 is connected to a workstation 507, and the electronic control device 501 develops image data (bit map data) based on print data sent from the workstation 507 and transfers the developed image data to the laser engine 505 via the connector CN10. The laser engine 505 drives the xerography unit 15 according to this and prints the image on the paper P.

As shown in FIG. 15, inside the electronic control device 501 are disposed a commonly used CPU (Motorola's MC68000 in this embodiment), a ROM 511 that stores the programs executed by the CPU 510, a RAM where print data or image data subsequent to being developed are stored, a data input port 514 that receives print data from the host workstation 505, a line buffer 515 connected to the bus line 516 which exchanges data with the cartridge 503, a register 517 for exchanging commands and status information with the laser engine 505, a console panel I/F 519 that serves as the interface with the console panel 518 of the laser printer 500, and a double-buffer circuit 520 where the image data to be transferred to the laser engine 505 are stored.

The double-buffer circuit 520 is equipped with the RAMs 520A and 520B, capable of holding 8 lines of print data, i.e., 4-kilobyte capacity, for printing by the laser engine 505, and image data from the CPU 510 are written alternately to these RAMs by the memory write controller 520C. The laser engine 505 performs printing by reading these two RAMs 520A and 520B alternately via the memory read controller 520D and converting the image data to a video signal in sync with the rotation of the photosensitive drum. These two RAMs 520A and 520B are provided and written and read alternately because access from the CPU 510 and access from the laser engine 505 must be performed independently.

After the CPU 510 has written data to one RAM, it sets a flag at a prescribed bit in the register 517. In response, the laser engine checks this flag and reads the image data stored in the RAM where the data were written. During reading, it sets a flag at another bit in the register 517 to let the CPU 510 know which RAM is being read. Since the other RAM is not accessed by the laser engine 505 at this time, the CPU 510 writes the next 8 lines of image data to this RAM during this time. When the laser engine 505 finishes reading from one RAM, it resets the flag and switches to reading from the other RAM. Since the speed with which the CPU 510 writes data is faster than the speed with which the laser engine 505 reads data, i.e., speed with which printing is executed, it is easy to avoid interference between memory access by the two and realize the reliable transfer of one page of image data.

The cartridge 503 is connected to the electronic control device 501 via the connector CN11. The line buffer 515 has a bus driver (not shown) inserted in the data bus 34. This bus driver is a one-way buffer that transfers data only from the connector CN11 to the CPU 510. In other words, as seen from the CPU 510, the cartridge 503 connected to the connector CN11 is a read-only device.

The electronic control device 501 judges whether or not the cartridge 503 is installed in the connector CN11 at the time of power on, and if it is judged to be installed, then after resetting, etc., are performed in the electronic control device 501, it jumps to a prescribed address in the ROM (described below) provided in the cartridge 503, after which the processing provided in the cartridge 503 is executed in sequence. The cartridge 503 interprets the program generated by the page description language and output from the workstation 507 to the laser printer 500 and develops it into image data and the laser engine 505 performs printing.

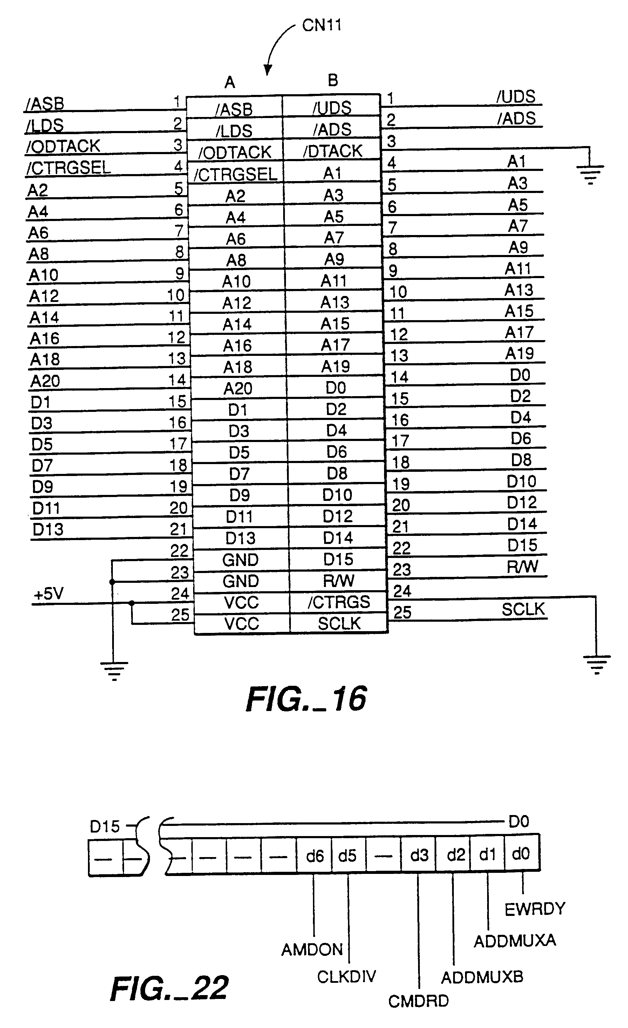

FIG. 16 shows the wiring relationship between the plug 551 formed on the end of the printed circuit board 550 and the connector CN11. The plug 551 has 25 terminals formed on each of the two sides (A side and B side) of the two-sided printed circuit board. FIG. 16 lists the signal names corresponding to each of the terminals of the plug 551. The slash (/) attached to the front of signal names indicates that the signal is low active. The meaning of each of the signals is as follows.

Signal /ASB: address strobe signal output by the CPU 510 (MC68000, Motorola Corporation).

Signal /UDS: upper data strobe signal output by the CPU 510.

Signal /LDS: lower data strobe signal output by the CPU 510.

Signal /ADS: auxiliary address strobe signal generated based on the address strobe signal /ASB in the electronic control device 501. This auxiliary address strobe signal /ADS demonstrates different behavior in different types of printers when the printer is initialized. In this embodiment, as described below, the printer type is judged based on the behavior of this auxiliary address strobe signal /ADS at the time of initialization.

Signal /ODTACK: output data acknowledge signal for when data are transferred from the cartridge 503 to the electronic control device 501.

Signal /CTRGSEL: cartridge selection signal when the CPU 510 selects the cartridge 503 and accesses the ROM, register, etc., assigned to the address space inside the cartridge.

Signals A1-A20: address signals output by the CPU 510.

Signals D1-D15: output signals from the cartridge 503.

Signal R/W: read-write signal output by the CPU 510.

Signal SCLK: clock signal output from the oscillator (not shown) built into the laser printer 500.

The signal /CTRGS supplied to the laser printer 500 becomes low level when the cartridge 503 is inserted, and the CPU 510 detects that the cartridge 503 has been inserted in the connector CN11 by this.

The CPU 510 specifies word addresses using the 23-bit address signals A1 to A23, and it specifies the upper byte and lower byte of each word using the signals /UDS and /LDS. As a result, the CPU 510 is capable of using the 16-megabyte address space from 000000h to FFFFFFh. The "h" added to the end of the address here is a hexadecimal indicator.

### B. Address Space of Cartridge

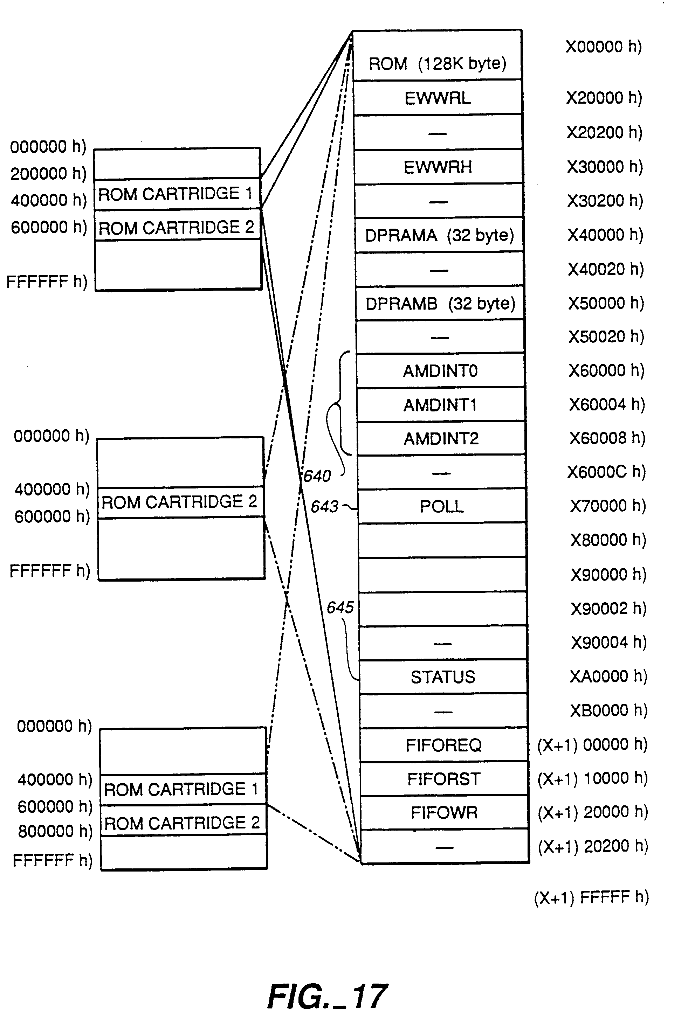

This cartridge 503 is assigned to part of the address space handled by the CPU 510 in the electronic control device 501. The CPU 510 handles the 16-megabyte address space from 000000h to FFFFFFh, but part of that is set aside for the ROM cartridge. The space assigned the cartridge 503 differs depending on the type of laser printer, but in the case of a Hewlett Packard laser printer, normally the 2-megabyte space from 200000h to 3FFFFFh or from 400000h to 5FFFFFh is assigned as shown on the left side of FIG. 17.

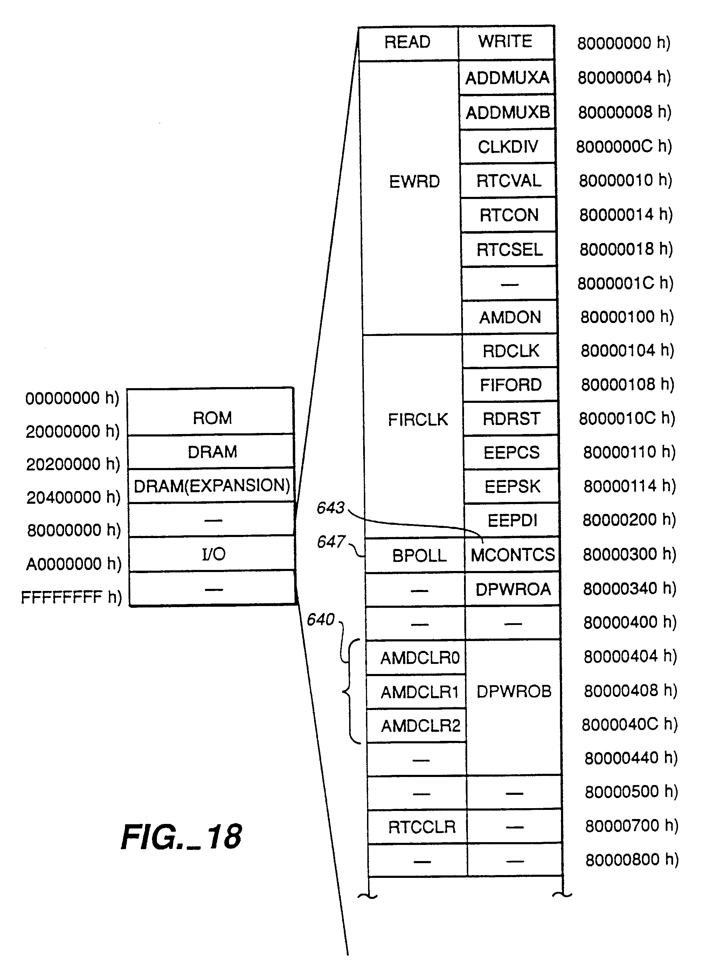

The microprocessor 601 disposed in the cartridge 503 of this embodiment is a 25-MHz AMD29030 produced by AMD Corporation, and the address space it can handle is 4 gigabytes from 00000000h to FFFFFFFFh. This address space is assigned to not only ROM or RAM but also to the various registers, etc., used to exchange data with the electronic control device 501 in the printer. This is shown in FIG. 18. Below, the internal electrical configuration of the cartridge 503 is explained together with the address space assignments for both microprocessors.

### C. Internal Configuration of Cartridge

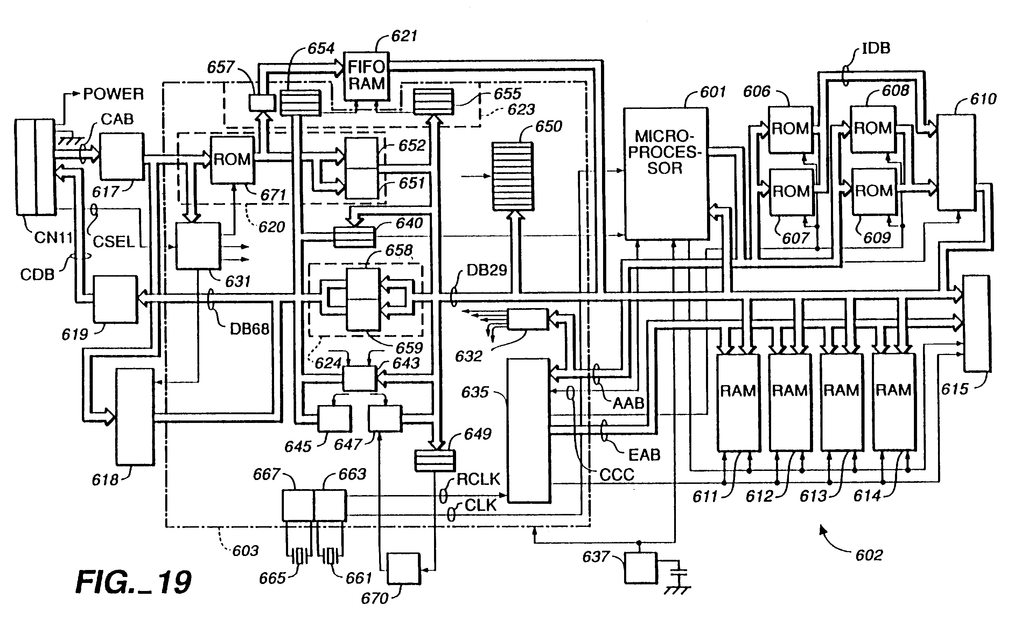

The internal configuration of the cartridge 503 is shown in FIG. 19. As shown in the figure, the cartridge 503 is configured around the microprocessor 601, which handles all control, and comprises mainly the memory section 602 made up of the ROM, RAM and their peripheral circuitry, the data transfer controller 603, which handles all exchange of data with the electronic control device 501, and other circuits.

The memory section 602 comprises ROMs 606 to 609, totaling 2 megabytes, where the programs executed by the microprocessor 601 are stored, the selector 610 for facilitating use of the ROMs 606 to 609 by bank selection, and the RAMs 611 to 614, totaling 2 megabytes, where the print data from the electronic control device 501 are stored or the image data after being developed are stored. The ROMs 606 to 609, totaling 2 megabytes, are each 4-megabit (16 bits x 256 kilobits) mask ROM, and as shown in FIG. 18, they are assigned the address space 00000000h to 001FFFFFh. The ROMs 606 and 607 and the ROMs 608 and 609 each make up a bank, and each bank of two make up a 32-bit data bus. The ROMs 606 to 609 and the microprocessor 601 are connected via the address bus AAB and the control signal bus. Further, the data bus IDB of the ROMs 606 to 609 is connected to the data bus DB29 via the data selector 610, whereby the microprocessor 601 is capable of reading data from the ROMs 606 to 609.

Except for the least significant 3 bits (A0, A1, A2) of the address bus AAB from the microprocessor 601, all address signals are input to the ROMs 606 and 607 and the ROMs 608 and 609. The least significant 2 bits (A0 and A1) are not input because the reading of data by the microprocessor 601 is done in 1-word = 32-bit units (4-byte units). Also, since the address A2 is not assigned, when data of a prescribed area are read, the four ROMs 606 to 609 output data simultaneously. That is, since access of ROM by the microprocessor 601 is often performed on consecutive addresses, two consecutive words, where one word is 32 bits, are read from ROMs 606 to 609 at one time, and when words that are actually consecutive are read, the bank to which the ROM belongs is sequentially switched by the data selector 610 to facilitate the reading of contiguous data. As a result, the reading of data in two contiguous words is extremely fast.

RAMs 611 to 614, on the other hand, are 16-bit x 256-kilobit = 4-megabit DRAM, and as shown in FIG. 18, they are assigned to the two megabytes of address space from 20000000h to 201FFFFFh. The memory in the cartridge 503 can be increased by 2 megabytes, for which the expansion RAM interface 615 is provided. This expansion RAM interface 615 is assigned to the address space from 20200000h to 203FFFFFh. Up to 2 megabytes of SIMM type RAM can be installed in the expansion RAM interface 615. The data line of RAMs 611 to 614 and the expansion RAM interface 615 are connected directly to the data bus DB29 of the microprocessor 601, and the address line is connected to the address bus AAB of the microprocessor 601 via the data transfer controller 603. The I/O of each of the registers, etc., described below is assigned to the address space beginning from 80000000h.

When the cartridge 503 is seen from the electronic control device 501 of the printer 500, the ROM is assigned the top 128 kilobytes as shown on the right side of FIG. 17. That is, this cartridge 503 contains the program executed by the CPU 510 of the electronic control device 501, and when the cartridge 503 is installed, the CPU 510 executes a jump instruction to go to a prescribed address in this ROM upon completion of initialization. Following this, the CPU 510 operates according to the procedure stored in this ROM.

When the CPU 510 accesses this 128-kilobyte space beginning from the top of the 2-megabyte space assigned to the cartridge 503, the ROM 618 is accessed by the address signal output via the address buffer 617 provided in the address bus CAB for the connector of the cartridge 503, and the instructions and data stored in this ROM 618 are sent to the CPU 510 in the electronic control device 501 via the data buffer 619 provided in the data bus CDB for the connector. In FIG. 17, "X" indicates the value of the most significant 4 bits of the top address of the assigned space.

### D. Explanation of Data Transfer Controller 603

In the address map shown in FIG. 17 and FIG. 18, addresses other than the addresses assigned to ROM and RAM contain the various control registers and status registers. Since these registers are realized by the data transfer controller 603, the data transfer controller will be explained next. The explanation will center around the circuitry, but the address maps (FIG. 17 and FIG. 18) are referred to as required.

The data transfer controller 603 shown in FIG. 19 is realized by means of the ASIC of the usable gate 7900. This ASIC is a standard cell, model No. SSC3630, produced by Seiko Epson Corporation, and it is a low-power element manufactured by a CMOS process. The data transfer controller 603 was designed using Seiko Epson's ASIC design system, LADSNET, which is a CAD system. This CAD system contains latches, flip-flops, counters, programmable logic arrays and other elements used in logic circuit design in the form of libraries, and after the required logic circuit is designed using these, the pattern of the ASIC can be automatically generated.

The data transfer controller 603 realized as an ASIC controls the exchange of data between the CPU 510 of the electronic control device 501 and the microprocessor 601 of the cartridge 503 when the cartridge 503 is installed in the connector CN11 of the printer 500. The exchange of data between these two is realized by means of the read control circuit 620 for sending data from the electronic control device 501 to the cartridge 503 via the read-only data bus, the FIFO control circuit 623, which performs the same function by passing data via the FIFO memory 621 using part of the configuration of the read control circuit 620, and the double-bank control circuit 624, which makes it possible to read data prepared by the cartridge 503 from the electronic control device 501. The FIFO memory 621 is a RAM that stores and reads data based on a first-in-first-out procedure, and in this embodiment, Mitsubishi Electric's M66252FP is used.

The address bus CAB is connected to the data transfer controller 603 via the address buffer 617 and the data bus CDB is connected to the electronic control device 501 via the data buffer 619 as signal lines with the electronic control device 501. Inside the data transfer controller 603 is a first decoder 631 that receives the signal of this address bus CAB and the cartridge select signal CSEL and outputs a selection signal to the respective parts inside the data transfer controller 603. In a similar manner, the address bus AAB and control signal CCC from the microprocessor 601 are connected to the data transfer controller 603, and inside the data transfer controller 603 is a second decoder 632 that receives this address bus AAB and outputs a selection signal to each of the internal circuits. There is also a bus controller that receives this address bus AAB and control signal CCC and outputs address signals and control signals to ROMs 606 to 609, RAMs 611 to 614 and the expansion RAM interface 615.

In addition to these, the data transfer controller 603 also contains various registers, a number of which are automatically written to when a specific process is performed in addition to those that are read from and written to by normal read-write operation. The configuration of these special registers is described below. In a relationship that treats the cartridge 503 as a read-only device as seen from the electronic control device 501, the registers writable from the electronic control device 501 have a configuration whereby they are written by performing reading from a prescribed address. That is, by specifying a prescribed address, a selection signal is output from the first decoder 631, and the data are written to the register by this signal. Reading from the register is performed by a normal read cycle. Further, the reading and writing of data from the microprocessor 601 are performed by normal read-write operation. In FIG. 19, registers are shown connected to a readable bus and writing operation is indicated by only arrows. These registers include the interrupt request registers 640, the polling command registers 643, the status registers (register STATUS in FIG. 17) 645, the transfer flag registers (register BPOLL in FIG. 18) 647, the PROM control registers 649 and the control registers 650.

Except for the status registers 645 and the transfer flag registers 647, all of these registers are generic names for multiple registers assigned as memory mapped I/O to the CPU 510 of the electronic control device 501 or the microprocessor 601 of the cartridge 503. The multiple registers are not necessarily assigned contiguous addresses. The interrupt request registers 640 include the registers AMDINT0, -1 and -2 and the registers AMDCLR0, -1 and -2 shown in FIG. 17 and FIG. 18. The polling command registers 643 include the register POLL and the register MCONTCS. The PROM control registers include the registers EEPCS, EEPSK and EEPDI.

The control registers 650 include those registers not belonging to the read control circuit 620, the FIFO control circuit 623 and the double-bank control circuit 624 and are all those registers not mentioned in the above explanation. These are the registers ADDMUXA, ADDMUXB, CLKDIV, RTCVAL, RTCON, RTCSEL, RTCCLR and SYSKEEP shown in FIG. 17 and FIG. 18.

Each of the 512-byte areas EWWRL and EWWRH shown in the memory maps in FIG. 17 and FIG. 18 are used to write from the electronic control device 501 to the first and second latches 651 and 652 of the read control circuit 620, and the register EWRD corresponds to these latches 651 and 652 seen as one word from the microprocessor 601. The registers FIFOREQ, FIFORST and FIFOWR correspond to the FIFO register 653 of the FIFO control circuit 623, and the registers FIRCLK, RDCLK, FIFORD and RDRST correspond to the FIFO read register 655 of the FIFO control circuit 623. The FIFO control circuit 623 has a latch 657 that uses some of the functions of the read control circuit 620 to retain the data to be written to FIFO memory 621.

The area indicated by the codes DPRAMA and DPRAMB in FIG. 17 are buffers with a 32-byte capacity, and they correspond to the first and second buffers 658 and 659 of the double-bank control circuit 624 as seen from the electronic control device 501. These buffers 658 and 659 as seen from the microprocessor 601 are the banks DPWROA and DPWROB shown in FIG. 18. The prescribed bits d1 and d2 of the status register 645 are used in the exchange of data via the double-bank control circuit 624, but that is discussed in detail later.

### E. Explanation of Registers

The interrupt request register 640 generates the request for an interrupt from the electronic control device 501 to the microprocessor 601 and retains it. Interrupts from the electronic control device 501 to the microprocessor 601 are prepared in three levels, and as shown in FIG. 17, they have three registers (AMDINT0, -1, -2). By reading one of these interrupt request registers 640 from the electronic control device 501, an interrupt request for the microprocessor 601 is generated. These registers are set by a read operation from the electronic control device 501, but the data read has no meaning and is not related to the generation of an interrupt request.

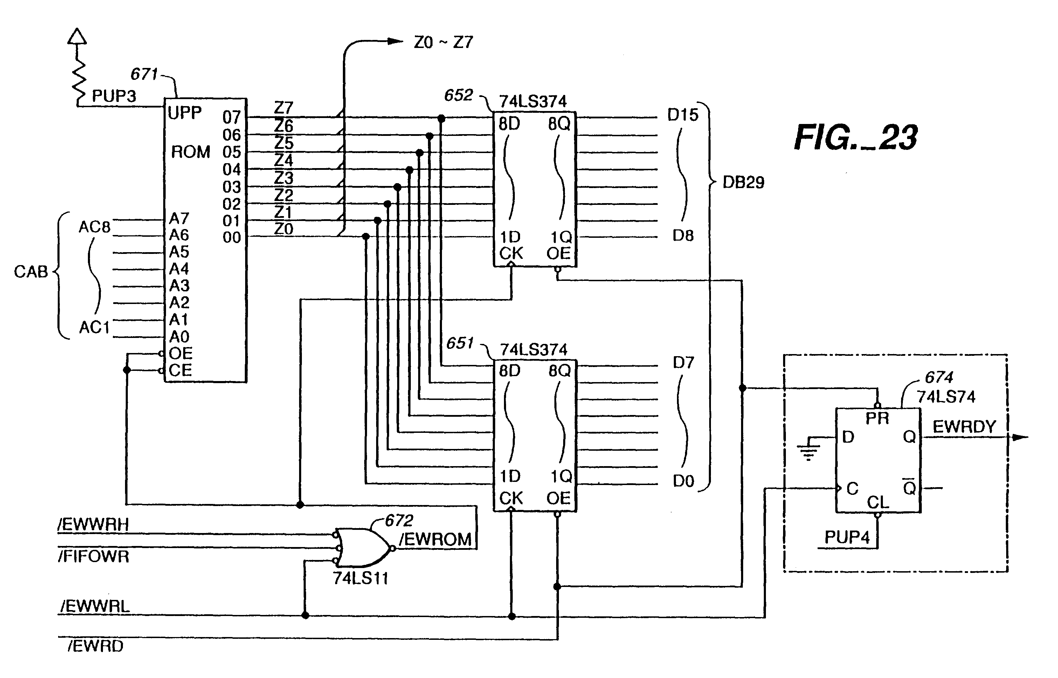

Specific examples of configurations of these interrupt request registers 640 are shown in FIG. 23. These registers are configured from D-type flip-flops, and the output terminal Q of each of the flip-flops 640a, -b and -c are set to active low by the signals /AMDINT0, -1 and -2 output by the first decoder 631 by the read operation of the above registers from the electronic control device 501, resulting in the output of the interrupt signals /INT0, -1 and -2. The slash (/) affixed to the front of signal names indicates that that signal is low active (same below). The registers that clear the outputs of these flip-flops 640a, -b and -c are assigned, as shown in FIG. 18, to prescribed addresses as three read-only registers (AMDCLR0, -1, -2). Therefore, when reading of each of the addresses assigned to these registers is performed by the microprocessor 601, the second decoder 632 outputs each of the signals /INTCLR0, -1 and -2), and the corresponding flip-flops are preset.

When an interrupt request is given from the electronic control device 501, any of the interrupt request registers 640 can be accessed, and the microprocessor 601 judges the precedence and performs processing in response to the interrupt requests. In this case, the microprocessor 601 clears the corresponding interrupt request registers 640a, -b and -c. Signals such as PUP2 that start with the code PUP are signals output from the reset signal output circuit 637 and become low level at the time of reset, etc. The signal PUP2 shown in FIG. 23 is used to clear three interrupt requests at once.

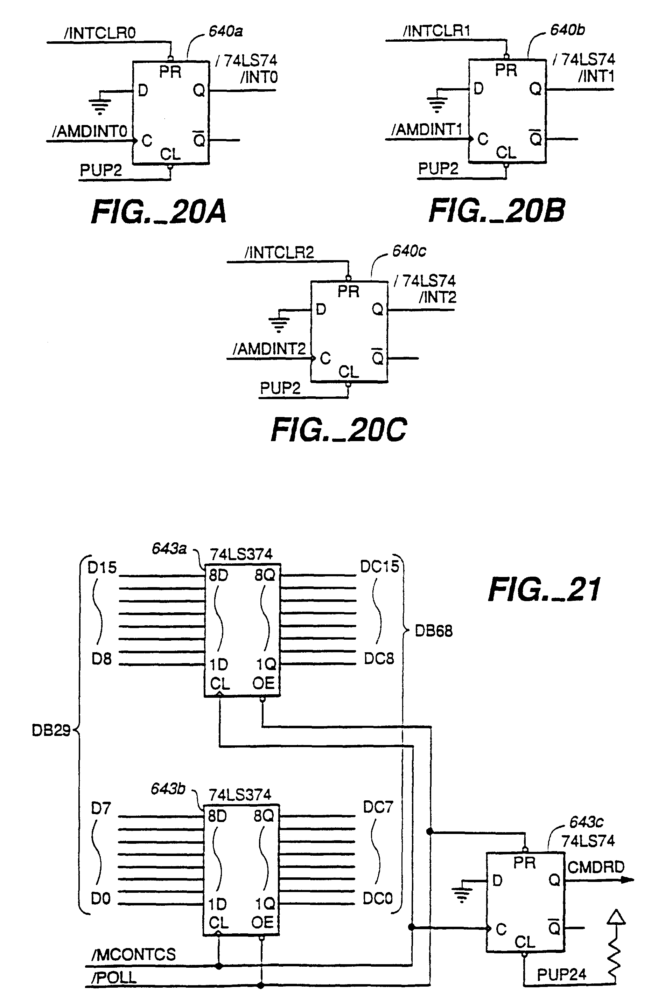

The polling command registers 643 are used to pass commands from the microprocessor 601 to the electronic control device 501, and these registers are writable by the microprocessor 601 and readable by the electronic control device 501. An example of a hardware configuration of these registers is shown in FIG. 20. As shown in the figure, the polling command registers 643 comprise two octal D-type flip-flops 643a and -b and one D-type flip-flop 643c, which make up a 16-bit-wide data latch.

The data bus DB29 (16-bit-wide bus) from the microprocessor 601 is connected to the data input terminals 1D to 8D of the octal D-type flip-flops 643a and -b, and the data bus DB68 (16-bit-wide bus) from the electronic control device 501 is connected to the output terminals 1Q to 8Q. The signal /MCONTCS output from the second decoder 632 at the time of access (register MCONTCS in FIG. 18) of the polling command registers 643 by the microprocessor 601 is connected to the clock terminal CK of the octal D-type flip-flops 643a and -b, and when this signal becomes active low, the contents of the data bus DB29 of the microprocessor 601 are latched in the octal D-type flip-flops 643a and -b. Further, the signal /POLL output from the first decoder 631 at the time of access (register POLL in FIG. 17) of the polling command registers 643 by the electronic control device 501 is connected to the output-enable terminal OE, which enables the output of the octal D-type flip-flops 643a and -b, and when this signal becomes low active, the data latched in the octal D-type flip-flops 643a and -b are output to the data bus DB68 of the electronic control device 501.

The signal /MCONTCS and the signal /POLL are connected to the clock terminal C and preset terminal PR of the D-type flip-flop 643c, and the signal CMDRD from the output terminal Q is set to high level when the octal D-type flip-flops 643a and -b latch data (signal /MCONTCS is low level) and to low level when these data are read by the electronic control device 501 (signal /POLL is low level). The signal CMDRD output from the D-type flip-flop 643c becomes the prescribed bit d3 (flag CMDRD below) of the status registers 645, which are readable by the electronic control device 501. Therefore, when the electronic control device 501 reads the status registers 645, the electronic control device 501 can know that a command was set in the polling command registers 643 from the microprocessor 601.

When the electronic control device 501 looks at flag CMDRD, which is bit d3 of the status registers 645, and knows that a command has been sent, it reads the contents of the polling command registers 643, i.e., command sent from microprocessor 601, in a normal read cycle. The command may be an instruction to begin transfer of the print data to the data transfer controller 603, an instruction to begin printing or the display of a message in the console panel 518. When the electronic control device 501 reads the contents of the polling command registers 643, the output signal CMDRD of the D-type flip-flop 643c is inverted to high level by the signal /POLL as shown in FIG. 20. Therefore, the microprocessor 601 can know whether or not the command it output was read by the electronic control device 501 by monitoring the prescribed bit d2 of this transferred flag register 647.

In addition to the above-described information that indicates the whether or not a command has been set from the microprocessor 601, the status registers 645 also hold the information shown in FIG. 21. A description of each bit is given below. Bit d0 is set to low level by the signal EWRDY generated in the read control circuit 620 when data are written to the read control circuit 620 from the electronic control device 501, and when those data are read by the microprocessor 601, bit d0 is set to high level by a signal from the second decoder 632. This bit is called flag EWRDY.

Bits d1 and d2 indicate whether the double-bank control circuit 624 can be accessed from the electronic control device 501 or the microprocessor 601, and they're respectively referred to as flag ADDMUXA and ADDMUXB. These two bits correspond respectively to the two transfer banks built into the double-bank control circuit 624. These bits d1 and d2 are set and reset by the microprocessor 601 writing data to bit d0 of the registers ADDMUXA and ADDMUXAB included in the control registers 650 as shown in FIG. 18. Therefore, by setting this flag to low level before the microprocessor 601 writes data to one of the banks of the double-bank control circuit 624 and resetting it to high level upon completion of writing and having the electronic control device 501 read data from the bank for which the flag is high level, data can be passed continuously from the microprocessor 601 to the electronic control device 501 by alternately writing data to and reading data from these two banks.

Bit d3 (flag CMDRD) has already been described. Bit d5 is flag CLKDIV, which is set based on the operation clock of the microprocessor 601. The operation clock of the microprocessor 601 is the clock CLK output from the first oscillator 661, which uses an externally attached liquid crystal vibrator CRC1, and when the microprocessor 601 writes level 0 to the prescribed bit d0 of the register CLKDIV of the control register 650, the operation CLK of the microprocessor 601 becomes 25 MHz, and when level 1 is written to bit d0, then the operation clock becomes 12.5 MHz. The flag CLKDIV of the status registers 645 as seen from the electronic control device 501 is set to low level when this clock CLK is 25 MHz and to high level when it is 12.5 MHz. When it is necessary for the electronic control device 501 to know the frequency of the operating clock, i.e., operating speed, of the microprocessor 601 in order to match timing for data transfer, etc., it checks this bit of the status registers 645.

Bit d6 is the flag ADMON, which is set to high level when the microprocessor 601 is operating and to low level when it enters the sleep mode. In this embodiment, the microprocessor 601 performs processing that receives the page description language from the electronic control device 501 and develops it into image data, and therefore when a prescribed amount of time has elapsed during which no page description language to be processed is sent from the electronic control device 501, the microprocessor 601 reduces its initial operating frequency by one half to 12.5 MHz in order to reduce power consumption, and after more time has elapsed, it stops its own operation and enters the so-called "sleep mode." At this time, the microprocessor 601 writes level 0 to register ADMON of the control register 650. As a result, this bit d6 of the status registers 645 becomes low level as seen from the electronic control device 501, and by checking this bit, the electronic control device 501 can know the operating mode of the microprocessor 601.

This time is measured with a real-time clock built into the data transfer controller 603. The clock RCLK for this real-time clock is a clock from the second oscillator 667 configured using an externally attached liquid crystal vibrator 665. The real-time clock is disposed inside the bus controller 635, and it receives instructions from the microprocessor 601 to measure the elapse of prescribed time periods. The reason why two sets of liquid crystal vibrators and oscillators are employed is to make it possible to change the operating clock CLK of the microprocessor 601 independently of the operating clock RCLK of the real-time clock.

The real-time clock sets the d1 bit of registers RTCVAL and RTCSEL, which belong to the control registers 650, to low or high, and it is capable of specifying four interval timers, which it can start by writing level 1 to the prescribed bit d0 of the register RTCON. A timer that has been started outputs an interrupt request signal to the microprocessor 601 at prescribed intervals until level 0 is written to bit d0 of register RTCON and it is stopped. When the microprocessor 601 receives this interrupt request signal, it reads register RTCCLR and clears the interrupt request. The output of these interval timers are used for counting user time, etc., in the processing of the page description language.

Next is an explanation of the configuration of the PROM control registers 649. The PROM control registers 649 include the registers EEPCS, EEPSK and EEPDI shown in FIG. 18, but these registers are memory built into the cartridge 503 and are used to exchange data with the EEPROM 670, which is capable of electrical erasure and rewriting of data.

The cartridge 503 of this embodiment stores the various variables (configuration) required for operation of the laser printer 500 in the EEPROM 670. This EEPROM 670 is one that reads, erases and writes data by serial transfer, and in this embodiment National Semiconductor's NMC93C66X3 is used. This EEPROM 670 has a storage capacity of 16 bits x 256 bytes (number of registers) and is capable of reading, erasing or writing the contents of any specified register. When the EEPROM 670 is set to a selection condition by the chip select signal CS, the "0" and "1" data sent to the serial data input terminal Din are received in sync with the serial data clock SL, but the first three transferred bits of the data are interpreted as a command to the EEPROM, and the next 8 bits are interpreted as the register number where the data are to be read, erased or written. In the case of writing data, the data to be stored are supplied to the data input terminal Din in sync with the serial data clock SL following these command and register specifications.

The register EEPCS switches the chip select signal, and when the microprocessor 601 writes level 1 to bit d0 of this register, the EEPROM 670 goes to a select condition. Register EEPSK generates the serial data clock SK, and when the microprocessor 601 alternately writes level 0 and level 1 to this register, it generates the serial data clock for the EEPROM 670. The register EEPDI holds the 1-bit data to be written to the EEPROM 670, and the microprocessor 601 rewrites the register EEPSK and rewrites the prescribed bit d0 of register EEPDI according to the data to be written in sync with the generation of the serial data clock SK. The data output terminal Dout of the EEPROM 670 is the prescribed bit d0 of the transfer flag register 647 explained above, and if the microprocessor 601 reads bit d0 of the transfer flag register 647 in sync with the serial data clock SK after it outputs the data read command and the number of the register to be read to the EEPROM 670, then it can read the contents of the specified register. Since the data stored in the EEPROM 670 are retained even after the power is turned off, the contents of the EEPROM 670 can be read immediately after the laser printer 500 is powered on again, thus making it possible to return the configuration to the condition it was in immediately before powering off.

### F. Configuration and Operation of Read Control Circuit 620

Next, an example configuration of the read control circuit 620 and a data transfer procedure using the read control circuit 620 are explained. The read control circuit 620 comprises two 8-bit first and second latches 651 and 652 in addition to, as shown in FIG. 22, a ROM 671 that outputs the data required for transfer, a three-input AND gate 672, and a D-type flip-flop 674 that generates the flag EWRDY (bit d0) for the status registers 645. When the read control circuit 620 is viewed from the electronic control device 501, these latches correspond to the two registers EWWRL and EWWRH, which transfer data in 8-bit units as shown in FIG. 17. These registers are used to transfer the lower byte and upper byte, respectively, of the 16-bits/word data. The first and second latches 651 and 652 correspond to the register EWRD shown in FIG. 18 when viewed from the microprocessor 601. That is, the microprocessor 601 can read both latches 651 and 652 as one word via the data bus DB290.

The ROM 671 of the read control circuit 620 stores 256 bytes of data; e.g., it can be realized with a fuse ROM, a low-capacity PROM, etc. Of course it may also be realized using part of a large-capacity ROM, and the same function can be achieved when RAM is used by transferring the data in advance. The lower 8 bits (AC1 to AC8) of the address line from the connector address bus CAB are connected to the address terminals A0 to A7 of the ROM 671, and the data terminals O0 to O7 are connected to the inputs 1D to 8D of the first latch 651 and the second latch 652. The outputs of ROM 671 are also output to the FIFO control circuit 623 as the data bus Z0 to Z7 for the FIFO control circuit 623.

The outputs of the first latch 651 and second latch 652 are connected to the data bus DB29, and these can be read by the microprocessor 601 as the register EWRD. The output signal /EWROM of the three-input AND gate 672 is input to chip select CE and output-enable OE of the ROM 671, and when any one of the signals /EWWRH, /FIFOWR and /EWWRL input to the three-input AND gate 672 becomes low active, this signal becomes active, at which time the ROM 671 outputs the data at the address specified by the lower 8 bits of the connector address bus CAB.

The signal /EWWRH becomes low level when transfer of the upper byte is specified by the read control circuit 620, the signal /EWWRL becomes low level when transfer of the lower byte is specified by same, and the signal /FIFOWR becomes low level when data transfer is specified by the FIFO control circuit 623. Since the signal /EWWRL and the signal /EWWRH are input to the clock terminals CK of the first latch 651 and the second latch 652, respectively, when these signals become active and data is output from ROM 671, these data are held in the first latch 651 and the second latch 652. Moreover, since the signal /EWWRL is input to the clock terminal C of the D-type flip-flop 674, the output Q of the D-type flip-flop 674 is inverted to low level when the lower byte is transferred. The output EWRDY is handled as bit d0 of the status registers 645 and bit d1 of the transfer flag registers 647, i.e., flag EWRDY.

The first latch 651 and second latch 652 are handled as register EWRD by the microprocessor 601, and therefore when the microprocessor 601 goes to read the data held by the first latch 651 and the second latch 652, it performs a read operation on the register EWRD. At this time, the signal EWRD becomes low level, and this signal outputs the previously held data from the output side of the first latch 651 and the second latch 652, i.e., to the data bus DB29, connected to the output-enable terminal. This signal /EWRD is connected to the preset terminal PR of the D-type flip-flop 674, and therefore the signal EWRDY, which is the Q output of the D-type flip-flop 674, is inverted to high level at the same time the microprocessor 601 reads the data of the first latch 651 and the second latch 652. That is, the flag EWRDY, which is bit d0 of the status registers 645 and bit d1 of the transfer flag registers 647, is set to level 1.

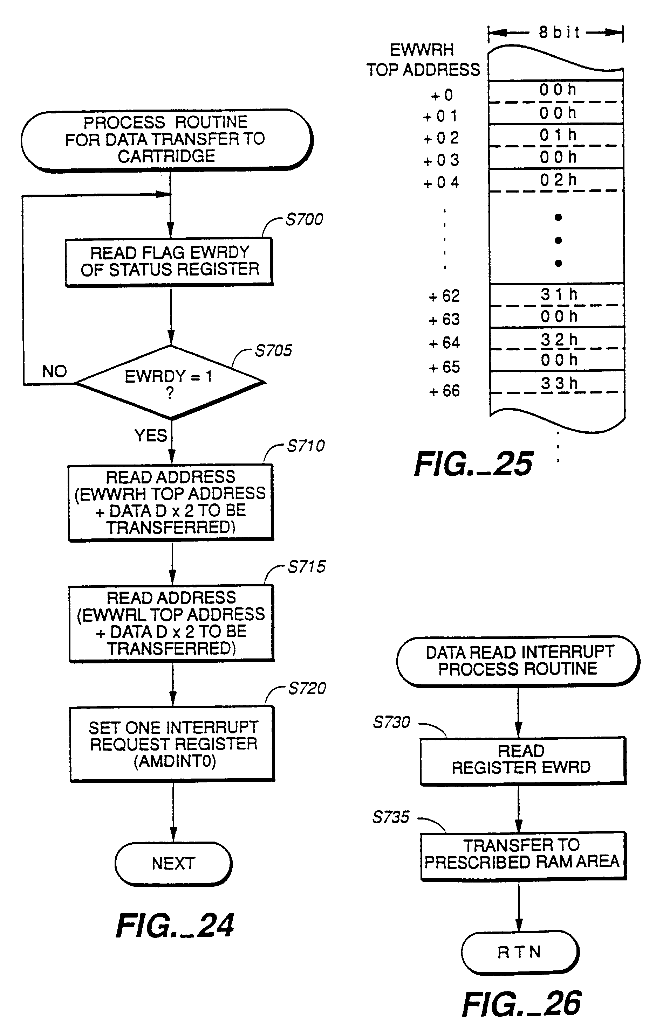

Assuming this hardware, the electronic control device 501 and the microprocessor 601 transfer data from the electronic control device 501 to the microprocessor 601 according to the following procedure. The data to be transferred from the electronic control device 501 to the microprocessor 601 is print data the electronic control device 501 has received from the workstation 507 and is the page description language program to be processed in the microprocessor 601 of the cartridge 503. Data transfer by the read control circuit 620 is performed by the routine for handling data transfer to the cartridge 503 executed by the CPU 510 of the electronic control device 501 (FIG. 24) and by the data read interrupt handler routine executed by the microprocessor 601 of the cartridge 503 (FIG. 26).

When the print data to be transferred to the cartridge 503 are complete, the CPU 510 initiates the processing shown in the flowchart in FIG. 24, whereby it first reads the flag EWRDY (bit d0) of the status registers 645 (step S700). This flag EWRDY (bit d0) becomes level 0 when data are set in the first latch 651 and the second latch 652 of the read control circuit 620, and when those data are read by the microprocessor 601, the flag is set to level 1, after which flag EWRDY is judged whether or not it has been set to level 1 (step S705).

The CPU 510 stands by until flag EWRDY becomes level 1, and when it becomes level 1, the CPU 510 performs processing that reads the addresses corresponding to [top address of area EWWRH + data D x 2 to be transferred]. When reading of the area EWWRH is performed, the data are output from ROM 671. As shown in FIG. 25, the 256 data at the even-numbered addresses from 00h to FFh from the top address EWWRH are written in order to ROM 671. The reason why data are not positioned at odd-numbered addresses is basically because data access by the CPU 510 is performed in single words (16 bits) and because word units cannot be accessed beginning from odd-numbered addresses (results in address bus error). When an address separated from the top of the area EWWRH by D x 2 is read, the data D from ROM 671 are read and are latched in the second latch 652 as shown in FIG. 22.

When transfer (second latch 652 holds data) of the upper byte of the data to be transferred is performed in this manner, the CPU 510 performs transfer of the lower byte (first latch 652 holds data) in the same manner (step S715). Assuming one word of data is being held by the first and second latches 651 and 652 as a result of the above processing, the CPU 510 performs processing that sets one interrupt request register (AMDINTO in this embodiment) (step S720).

The CPU 510 then repeatedly executes the transfer handler routine shown in FIG. 24, but when data are held by the first latch 651, the flag EWRDY is set to low level as shown in FIG. 22, and therefore the next data transfer is not processed until this flag EWRDY becomes high level (level 1) (steps S700, S705).

When the CPU 510 sets the interrupt request register (AMDINTO), the microprocessor 601 receives this interrupt request and initiates the data read interrupt handler routine shown in FIG. 26. This processing is initiated immediately after data are held in the first and second latches 651 and 652 in the read control circuit 620, and the microprocessor 601 reads the one word of data prepared by the electronic control device 501 by reading the register EWRD (step S730). Next, the microprocessor 601 transfers the data it just read to a prescribed area in RAMs 611 to 614 (step S735).

By means of the processing described above, the electronic control device 501 is capable of transferring data to the cartridge 503, which is connected by no more than the data bus CDB, which is a read-only line. Moreover, since data are written in byte units and are read in word units, the microprocessor 601 takes in data with great efficiency. This explanation covers the transfer of one word of data, but data do not have to be transferred in word units and can be transferred in byte units. In that case, only transfer that uses the area EWWRL is performed and the upper eight bits of data can be discarded by the microprocessor 601.

### G. Configuration and Operation of FIFO Control Circuit 623

The FIFO control circuit 623 is equipped with the latch 657 that latches the data to be written to the FIFO memory 621, the FIFO write registers 653 that control the writing of data to the FIFO memory 621 and the FIFO read registers 655 that control the reading of data from same. This FIFO memory 621 can hold 1152 bytes of data and is equipped internally with an address counter for writing and a counter for reading. The FIFO memory 621 also has a write reset terminal and a read reset terminal for resetting these respective counters, an 8-bit data bus on the write side, an 8-bit data bus on the read side, a clock terminal for writing and a clock terminal for reading.

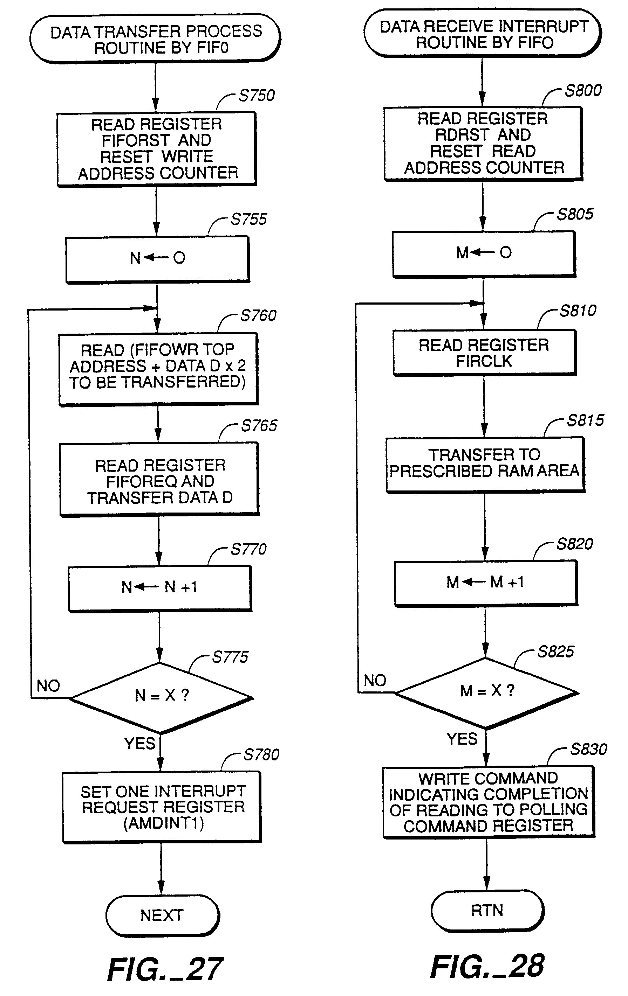

In utilizing this FIFO memory 621 to transfer data from the electronic control device 501 to the microprocessor 601, the CPU 510 in the electronic control device 501 executes the transfer handler routine shown in FIG. 27 and the microprocessor 601 of the cartridge 503 executes the handler routine shown in FIG. 28. First is an explanation of the handler routine shown in the flowchart in FIG. 27.

The CPU 510 of the electronic control device 501 uses the FIFO control circuit 623 to transfer several bytes of the data.

When the CPU 510 of the electronic control device 501 initiates the data transfer handler routine shown in FIG. 27, first the register FIFORST belonging to the FIFO write circuit 654 of the FIFO control circuit 623 is read and the write address counter is reset (step S750). Next, the variable N is reset to 0 to count the number of data to be read out (step S755). Following this, the addresses [top address of register FIFOWR + data D x 2 to be transferred] are read (step S760). When these addresses are read, a prescribed address in ROM 671 is accessed (see FIG. 25) in the same manner as the read control circuit 620, the data D to be transferred by the CPU 510 are output, and these are latched in latch 657 via the bus Z0 to Z7 shown in FIG. 22.

Next, the data D read from register FIFOREQ of the FIFO control circuit 623 and held in latch 657 are transferred to the FIFO memory 621 (step S765). When register FIFOREQ is read, a write clock is output to the write clock terminal of the FIFO memory 621, and the data D held in latch 657 are written to the address indicated by the write address counter of the FIFO memory 621. At the same time, the contents of the write address counter in the FIFO memory 621 are incremented by 1. When one byte of data is written in this manner, the variable N, which indicates the number of data transferred, is incremented by 1 (step S770), and judgment is performed to determine whether the variable N is equal to the total byte number X of the data to be transferred (step S775). Therefore, the processing in steps S760 to S775 is repeated until the byte number N of the transferred data is equal to the total byte number X of the data.

When all data have been transferred, the CPU 510 sets one of the interrupt request registers (AMDINT1) to notify the microprocessor 601 that the transfer of data is complete (step S780), after which the routine escapes to NEXT and is terminated.

The microprocessor 601, on the other hand, initiates the data receive interrupt routine shown in the flowchart in FIG. 28 when it receives this interrupt request AMDINT1. When this routine is initiated, the microprocessor 601 first reads the register RDRST belonging to the FIFO read registers 655 of the FIFO control circuit 623 and resets the address counter on the read side of the FIFO memory 621 (step S800). Next, the variable M for counting the number of received data is reset to 0 (step S805).

Following this, the register FIRCLK belonging to the FIFO read registers 655 is read (step S810), and the read data are transferred to a prescribed area in RAMs 611 to 614 (step S815). When the register FIRCLK is read, a read clock is output to the clock terminal on the read side of the FIFO memory 621, and the data D at the address indicated by the read address counter at that time are read out. At the same time, the contents of the read address counter in the FIFO memory 621 are incremented by 1. The reason why data are normally transferred via the FIFO control circuit 623 is because they are the page description language program, and the received data are transferred immediately to a prescribed area in RAM for the development of image data.

When one byte of data is received, the variable M is incremented by 1 (step S820), and the variable M is judged whether or not it is equal to the total byte number X (step S825) to be transferred. Therefore, the processing in steps S810 to S825 above is repeated until the byte number M of the received data equals the total number X for the data.

When it is judged that all data have been received, the microprocessor 610 writes a command to the polling command registers 643 that indicates the completion of the writing of data (step S630). The CPU 510 of the electronic control device 501 knows that data reception by the FIFO control circuit 623 is complete by reading the contents of the polling command registers 643. The microprocessor 601 then escapes to RTN and terminates this routine.

By means of the processing described above, large amounts of data can be efficiently transferred from the electronic control device 501 to the microprocessor 601. The transferred data are stored in a prescribed area in RAMs 611 to 614 of the data transfer controller 603 and wait for processing by the microprocessor 601. The microprocessor 601 receives all of the print data (program described by the page description language) to be developed by the electronic control device 501, activates the interpreter of the page description language stored in ROMs 606 to 609, and processes the print data stored in the prescribed area in RAMs 611 to 614. This processing develops the image, and the developed result is stored as image data in a prescribed area in RAMs 611 to 614.

### H. Configuration and Operation of Double-Bank Control Circuit 624

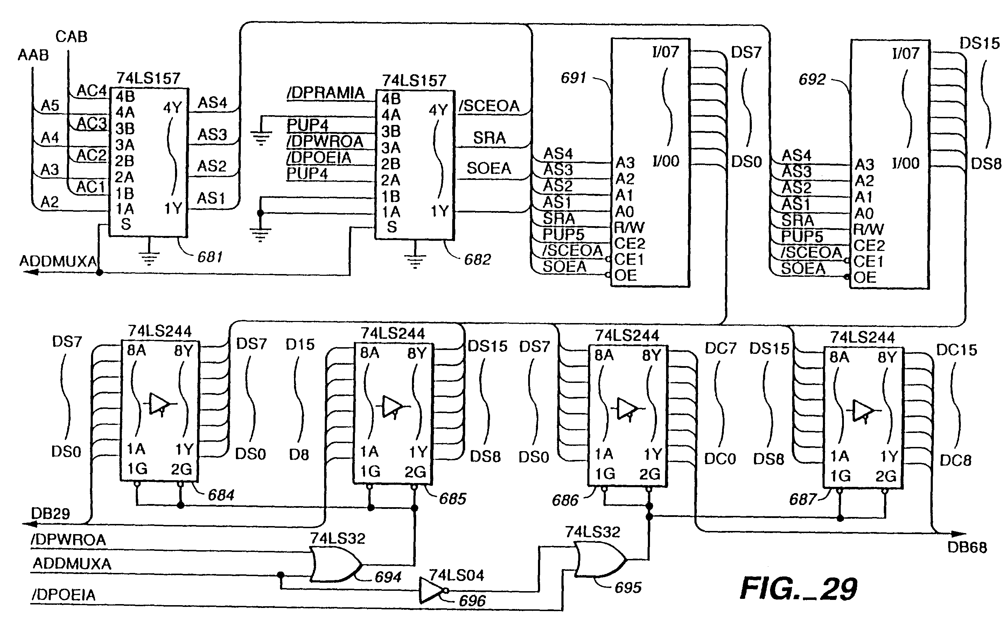

The image data obtained upon completion of image development are then transferred to the electronic control device 501, where they are stored in RAM 512 and printed by the laser engine 505 according to a prescribed timing. These image data are transferred by the double-bank control circuit 624. The double-bank control circuit 624 transfers from the microprocessor 601 to the electronic control device 501 and is equipped with two banks that store 32 bytes (16 words) of data. These are referred to as A bank and B bank, and since the hardware of both is exactly the same, only the configuration of A bank is shown in FIG. 29.

The address and data buses of each of these banks are configured such that they can be switched from the microprocessor 601 and from the electronic control device 501, and as shown in the figure, they are configured from the data selectors 681 and 682, which select the address line, the four octal line buffers 684 to 687, which are used in two sets of two each and select the data bus (16 bits wide), the RAMs 691 and 692, which have a 32-byte storage capacity, the OR gates 694 and 695, which make up the other gates, and the inverter 696. In FIG. 29, a configuration is shown in which two memory chips with a 32-byte storage capacity are used, but the memory can also be realized by switching the upper address of a single memory chip.

The data selector 681 is configured such that it selects the least significant four bits (AC1 to AC4) of the address bus CAB on the electronic control device 501 side and the lower four bits (A2 to A5) of the address bus AAB on the microprocessor 601 side and outputs them, and selection of the address bus is performed by the signal ADDMUXA (bit d0 of register ADDMUXA) connected to the select terminal S. The data selector 682 switches the read-write signal for the RAMs 691 and 692 in addition to selecting an address bus, and in a similar manner, the signal ADDMUXA connected to the select terminal S determines which signal is connected to the chip select terminals CE1 and -2 and the output-enable terminal OE by switching them.

The octal line buffers 684 and 685 are tristate line buffers connected to the data bus DB29, and when the gate terminals 1G and 2G become low level, the data bus DB29 on the microprocessor 601 side and the data bus of the RAMs 691 and 692 are connected, resulting in a condition that allows writing of data from the microprocessor 601 to RAMs 691 and 692. The output of the OR gate 694, whose inputs are the signal /DPWROA and the signal /DDMUXA, is connected to the gate terminals 1G and 2G of the octal line buffers 684 and 685. The signal /DPWROA becomes low level when the microprocessor 601 writes data to A bank. Therefore, by setting bit d0 of register ADDMUXA to low level in advance of writing data to A bank, when the microprocessor 601 does write data to A bank, the gates of the octal line buffers 684 and 685 open and the data output to the data bus DB29 are output to the data bus of RAMs 691 and 692, where they are written.

When the gate terminals 1G and 2G of the octal line buffers 686 and 687 become low level, the data bus DB68 on the electronic control device 501 side and the data bus of the RAMs 691 and 692 are connected, resulting in a condition in which data can be read out from RAMs 691 and 692 to the electronic control device 501. The output of the OR gate 695, whose inputs are the signal /DPOE1A and the signal ADDMUXA inverted in the inverter 696, is connected to the gate terminals 1G and 2G of the octal line buffers 686 and 687. The signal /DPOE1A becomes low level when the electronic control device 501 tries to read the data of A bank. Therefore, by setting bit d0 of register ADDMUXA to high level in advance of reading the data of A bank, the gates of the octal line buffers 686 and 687 open and the data output to the data bus of RAMs 691 and 692 are output to the data bus DB68 when the electronic control device 501 performs a read operation on A bank.

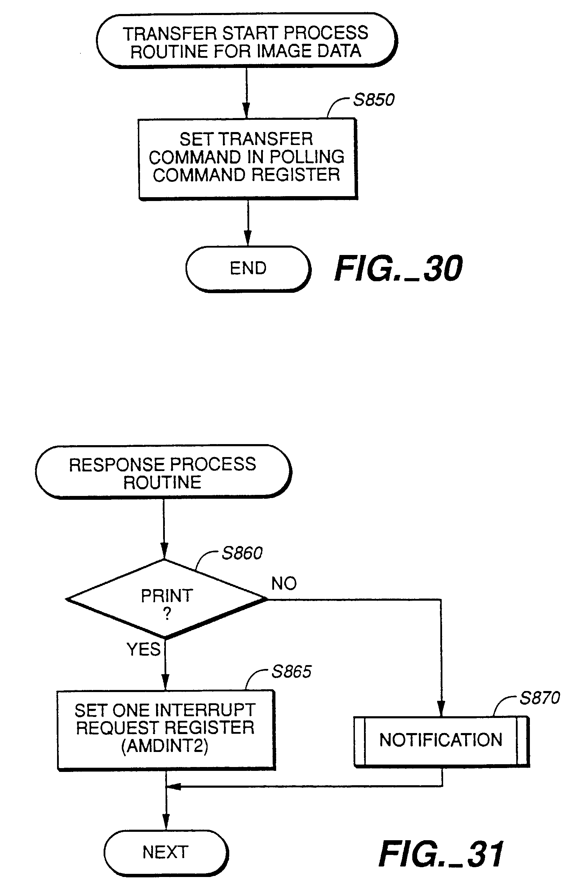

The transfer processing of image data by the microprocessor 601 and its receiving processing by the CPU 510 of the electronic control device 501 are explained below assuming this hardware. FIG. 30 is a flowchart showing the transfer start handler routine for image data executed by the microprocessor 601. As shown in the figure, the microprocessor 601 sets a transfer start command in the polling command register 643 before transferring image data (step S850).

The CPU 510 of the electronic control device 501 reads this polling command register 643 and executes the response handler routine shown in FIG. 31. That is, the electronic control device 501 judges whether or not the laser printer 500 is in a print-enabled condition (step S860), and if it judges that it is in a condition that will allow printing, then it sets one (AMDINT2) of the interrupt request registers (step S865) and escapes to NEXT and temporarily terminates the routine. If the printer is not in a condition that will allow printing, then the CPU 510 performs processing that notifies the microprocessor 601 of the cartridge 503 (step S870). A condition that will not allow printing is one in which the laser engine has not completely warmed up yet, or there is a paper jam or other condition that will not allow printing even though the image data have been received.

When the interrupt request signal AMDINT2 is received from the electronic control device 501, the microprocessor 601 initiates the data transfer interrupt handler routine shown in FIG. 31. When this processing is activated, the microprocessor 601 first writes level 1 to bit d0 of register ADDMUXA (step S900). When bit d0 of register ADDMUXA is level 1, the data bus of RAMs 691 and 692 is connected to the data bus DB29 on the microprocessor 601 side as was explained using FIG. 29, thus disabling access from the electronic control device 501.

Next the microprocessor 601 transfers 16 words (32 bytes) of data to A bank DPWROA (step S902). When data are written to A bank DPWROA, the signal /DPWROA shown in FIG. 29 becomes low level, and the data are written to RAMs 691 and 692 via the octal line buffers 684 and 685. Upon completion of transfer of the 16 words of data, the microprocessor 601 writes level 1 to bit d0 of register ADDMUXA (step S904), and the data bus of RAMs 691 and 692, which make up A bank, is connected to the data bus DB68 of the electronic control device 501.

The microprocessor 601 then writes the command data that notifies that transfer to A bank is complete to the polling command registers 643 (step S906). This completes transfer of data to A bank, and the microprocessor 601 then executes the same processing as above with respect to B bank (step S910). When data transfer to B bank is complete, the microprocessor 601 writes command data that notifies that transfer is complete in the same way to the polling command registers 643. In this way, the transfer of a total of 32 words (64 bytes) of data to A and B banks from the cartridge 503 is completed.

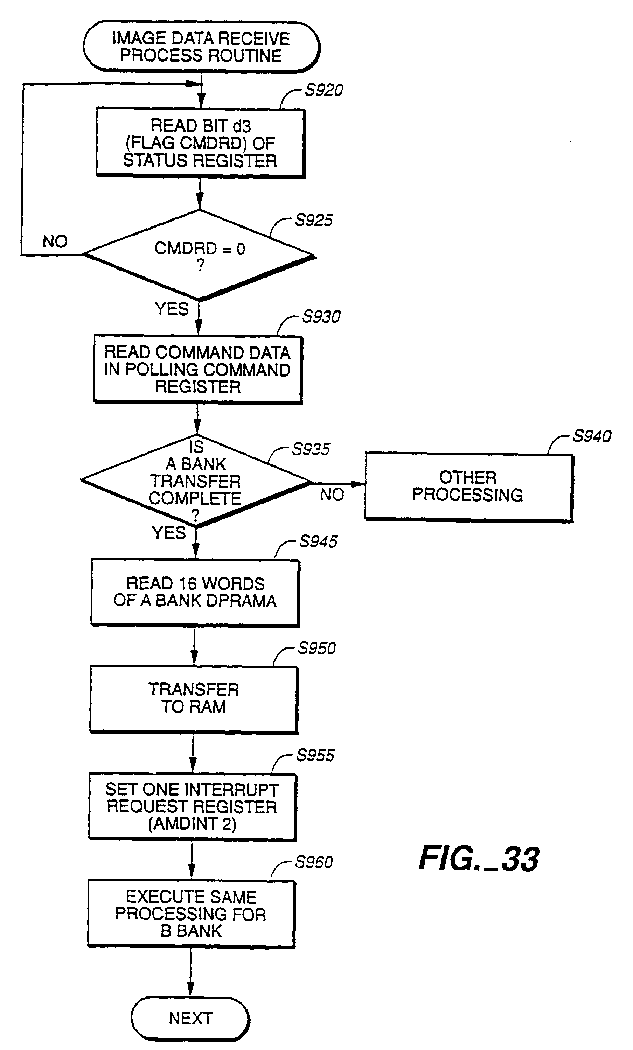

In response to the above processing performed by the microprocessor 601, the CPU 510 of the electronic control device 501 executes the image data receive handler routine shown in FIG. 33. That is, the CPU 510 first reads bit d3 of the status registers 645, i.e., flag CMDRD, (step S920) and judges whether or not it is at level 0 (step S925). When command data is written to the polling command registers 643 by the microprocessor 601, flag CMDRD is set to level 0, and therefore the CPU 510 reads the command data in the polling command registers 643 (step S930).

The CPU 510 checks the read command data and judges if it is command data that indicates that data transfer to A bank is complete (step S935), and if it is not, then the CPU 510 executes other processing (step S940). When the command data in the polling command register 643 indicate that data transfer to A bank is complete, the electronic control device 501 reads the 16 words in A bank DPRAMA (step S945; see FIG. 17) and transfers the read data to RAM 512 (step S950).

Since the above processing completes the reading of the 16 words of data in A bank, the electronic control device 501 sets one interrupt request register (AMDINT2) that will allow transfer of the next 16 words from the microprocessor 601. The processing in steps S920 to S955 is then repeated with respect to B bank. That is, when it is judged that the transfer of data by the microprocessor 601 from B bank has been completed based on the command data in the polling command registers 643, then one interrupt request register is set to send an interrupt request to the microprocessor 601 after the 16 words of data in B bank DPRAMB are read and transferred to RAM 512.

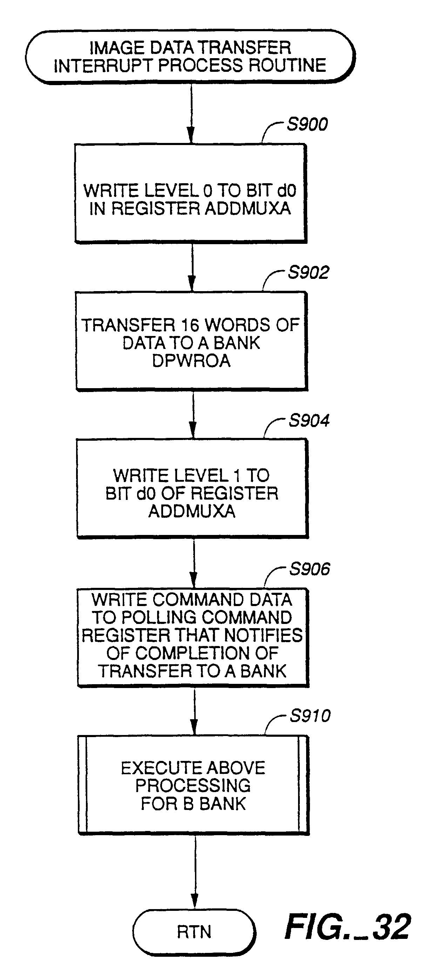

When it receives the interrupt request, the microprocessor 601 executes the interrupt handler routine shown in FIG. 32 again, and therefore the microprocessor 601 and CPU 510 complete the transfer of all image data by executing both routines (FIG. 32 and FIG. 33). If new print data are not received from the electronic control device 501 after all image data have been transferred, then the microprocessor 601 writes level 1 to register CLKDIV of the control registers 650 after a prescribed time period has elapsed and switches its own operating frequency by half, i.e., to 12.5 MHz, to reduce power consumption and reduce the amount of heat generated.

### I. Printing of Image Data

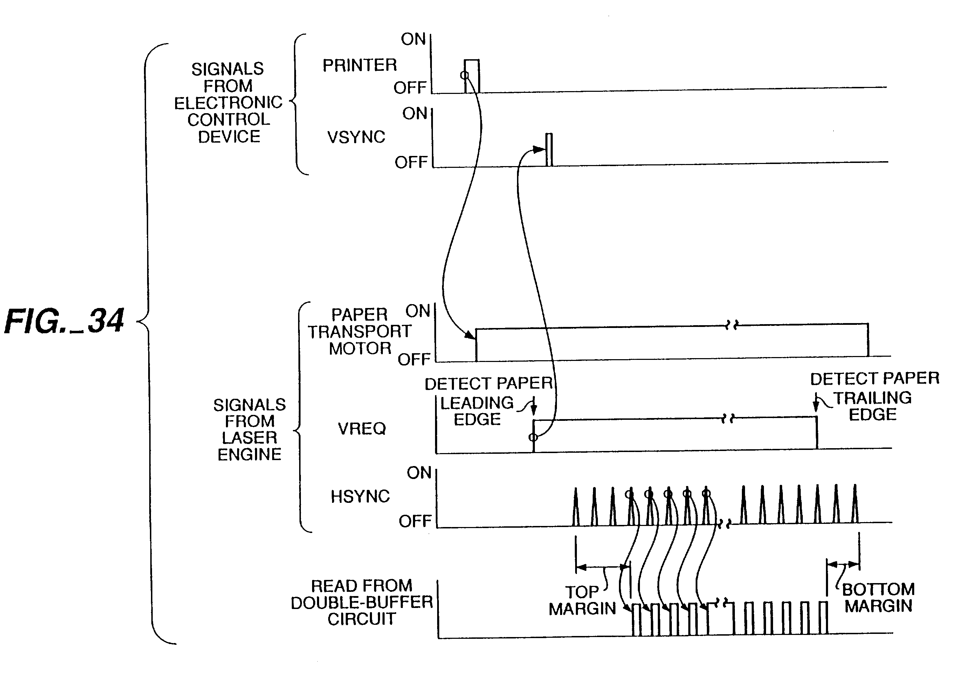

The electronic control device 501, which receives the transfer of all image data, prints the image data by exchanging signals with the laser engine 505 using the double-buffer circuit 520 and register 517 explained above. The exchange of signals between the electronic control device 501 and laser engine 505 is roughly depicted in FIG. 34. Printing is summarized below referring to this figure.

When the image data that have been developed are received from the cartridge 503, the electronic control device 501 inquires whether or not the laser engine 505 is in a print-enabled condition, and if it does judge that warming up, etc., are complete and the laser engine is in a print-enabled condition, then it outputs the print signals shown in FIG. 34 to the laser engine 505 via the register 517. When the laser engine 505 receives these signals, it immediately starts the motor for paper transport. Rotation of the photosensitive drum, charging processing, etc., are started in sync with this.

When the paper to be printed on reaches a position at a prescribed distance from the photosensitive drum, the laser engine 505 detects the end of the paper and outputs the signal VREQ to the electronic control device 501 via the register 517. When the electronic control device 501 receives this signal VREQ, it waits a prescribed period of time; i.e., the time required for the photosensitive drum to rotate to the position where formation of the latent image by the laser beam begins, and outputs the signal VSYNC via the register 517. When the laser engine 505 receives this signal VSYNC, it outputs the laser beam horizontal sync signal HSYNC via the register 517. Since this signal HSYNC is a signal that instructs to begin reading one line of image data, the laser engine 505 reads image data from either RAM 520A or RAM 520B of the double-buffer circuit 520 in sync with this signal. When there is a top margin, control is performed that ignores the signal VSYNC for the number of lines corresponding to the top margin. This control is the same when a bottom margin is formed.

At the same time, the CPU 510 counts this signal and transfers the necessary image data to RAM 520A or RAM 520B of the double-buffer circuit 520. When a prescribed amount of time has elapsed or the count of the horizontal sync signal becomes equal to a value previously set to conform with the paper size after the laser engine 505 detects the trailing edge of the paper, the CPU 510 terminates the transfer of image data to the double-buffer circuit 520. By means of the above processing, one page of image data is transferred to the laser engine and the image is printed on the paper.

### [iii] Other

(1) The embodiment explained above concerned the application of the invention to a printer, but application of the invention is not limited to printers; e.g., it can also be applied to word processors, personal computers and workstations. In recent years, in addition to expansion slots, many computer-related devices have the ability to accommodate cartridge-type expansion devices such as IC cards. By mounting the cartridge of the invention in a word processor, personal computer, etc., equipped with an expansion slot, IC card, etc., and shifting processing by the processor of the main unit to processing stored in the memory built into the cartridge by a monitor command, etc., and processing information together with the processor in the cartridge, the information processing function can be easily upgraded, added to or changed. Further, if control is shifted to the cartridge, the contents of the processing can be changed in any manner, and therefore the functions of devices that have already been purchased can be changed or improved and the software in word processors and other dedicated devices can be upgraded.
   In this way, the invention can be applied to all types of devices that employ a processor, e.g., electrical equipment for vehicles, facsimile machines, telephones, electronic notebooks, electronic musical instruments, electronic cameras, translating machines, handy copiers, cash dispensers, remote controllers, calculators and the cartridge of any other information processing device that can be connected via a connector. If the processor in the main unit of these types of information processing devices has a function that recognizes a cartridge and transfers its processing to an address prepared in the cartridge, the cartridge of the invention can be easily realized even in existing electronic devices. Even in cases in which this function is not provided, various means can be considered for shifting the processor of the main unit to processing stored in the cartridge.
   When the 68000 family of processors read data from a prescribed address, data on the data bus is judged to be fixed or not by the signal DTACK returned to the processor of the device (slave) outputting the data. Therefore, when the processor of the main unit attempts to execute a jump instruction to an absolute address while executing processing stored in ROM in the main unit, the cartridge analyzes the instruction and detects it as the execution of a jump instruction to an absolute address, and before the original ROM in the main unit can output the target absolute address of the jump to the data bus, the cartridge outputs the execution address in ROM in the cartridge to the data bus and returns the signal DTACK to the processor in the main unit, whereby processing is forcibly shifted to after a prescribed address in the cartridge. Once processing is shifted to ROM in the cartridge, subsequent processing can be configured in any manner.
   This example is premised on the execution of a jump instruction to an absolute address by the processor in the main unit, but since the jump instruction itself comes from ROM in the main unit, a configuration can be employed that supplies a code equivalent to the jump instruction from the cartridge to the data bus when the instruction is first read from ROM after powering on and also returns the signal DTACK. In these methods, there is a possibility of conflict with the signal DTACK, but the methods can be realized through careful analysis of the bus timing.
(2) The invention is not limited by the above embodiments; e.g., a configuration in which the cartridge, with built-in outline fonts, receives the character point size and other data from the printer, generates a bit image at the specified point size and transfers it to the printer, a configuration in which the data received from the electronic device is merely stored or displayed in the cartridge and does not undergo particularly complicated processing, a configuration in which the main printer unit is an ink jet printer, and other configurations are possible as long as they do not deviate from the invention as claimed.

### APPLICABILITY TO INDUSTRY

The cartridge for electronic devices of the invention can be applied to all types of devices that employ a processor, e.g., word processors, personal computers, workstations, electrical equipment for vehicles, facsimile machines, telephones, electronic pocketbooks, electronic musical instruments, electronic cameras, translating machines, handy copiers, cash dispensers, remote controllers, calculators and the cartridge of any other information processing device that can be connected via a connector.

## Claims

1. A cartridge for electronic devices adapted to be inserted in a prescribed insertion opening of an electronic device (1A, 1B) equipped with a first processor (510) capable of logic operation, wherein the cartridge (503) is equipped with a circuit board (550) on which are mounted the electronic components in the cartridge and to which a plug (551) for electrical connection to said electronic device is attached, a case (100, 120) that houses the circuit board and has a through-hole (142) through which said plug passes, and a conductive shielding member; connection means (104, 122) adapted to electrically connect a conductive member of the electronic device, the power source wiring on the circuit board and the shielding member;
**characterized in that** a conductive portion (566) connected to said shielding member is provided in at least one location of the through-hole of the case (100, 120) near to the middle of said plug (551).

2. The cartridge of claim 1 wherein the cartridge (503) is equipped with a second processor (601).

3. The cartridge of claim 2 wherein the case (100, 120) includes the shielding member.

4. The cartridge of claim 3 wherein at least part of the case (100, 120) is made from metal.

5. The cartridge of claim 3 wherein at least part of the case (100, 120) has a conductive layer.

6. The cartridge of claim 3 wherein the case is equipped with first and second case elements (100, 120) that house the circuit board (550), and the part of the cartridge (503) protruding from the electronic device (1A, 1B) when the cartridge is installed in the electronic device has conductive layers formed on the mating surfaces of each of the first and second case elements.

7. The cartridge of claim 6 wherein one of the first and second case elements (100, 120) is made of plastic and the other is made of metal.

8. The cartridge of any one of the preceding claims wherein the connection means (104, 122) electrically connects the power source wiring on the circuit board (550) to the shielding member at multiple locations.

9. The cartridge of claim 3 wherein the connection means (104, 122) is equipped with a conductive elastic member (122) secured to the shielding member, and the conductive elastic member has a protruding member (122B) that protrudes to the outside from an opening in the case (100, 120) and is adapted to be electrically connected to a conductive member of the electronic device (1A, 1B) when the cartridge (503) is inserted in the electronic device.

10. The cartridge of claim 9 wherein the cartridge (503) is equipped with multiple conductive elastic members (122) and at least one conductive elastic member is adapted to be electrically connected to a conductive member of the electronic device (1A, 1B) when the cartridge is inserted in the electronic device.

11. The cartridge of claim 10 wherein the multiple conductive elastic members (122) electrically connect the shielding member and the power source wiring on the circuit board (550).

12. The cartridge of claim 7 wherein the cartridge (503) is equipped with a metal heat dissipation member (110) secured to the metal case element (120) and disposed inside the case (100, 120) such that it opposes the top surface of the second processor (601), and an intervening member (102) that is disposed between the heat dissipation member and the top surface of the second processor and is in contact with the heat dissipation member and the second processor.

13. The cartridge of claim 12 wherein the cartridge (503) is equipped with an elastic member (126) for pushing the second processor (601) toward the heat dissipation member.

14. The cartridge of claim 3 wherein the circuit board (550) is equipped with a connector (219) for expansion memory (200).

15. The cartridge of claim 14 wherein the case (100, 120) has an expansion slot (106) for inserting the expansion memory (200) in the connector (210) for expansion memory and a removable expansion slot cover (150), and the expansion slot cover is disposed in a position that is hidden inside the electronic device (1A, 1B) when the cartridge (503) is inserted in the electronic device.

16. The cartridge of claim 15 wherein the expansion memory (200) is configured as an IC card.

17. The cartridge of claim 1 wherein the cartridge (503) is equipped with a joining means that mechanically joins the main electronic device (1A, 1B) unit and the cartridge (503) for electronic devices.

18. The cartridge of claim 17 wherein the joining means is provided with a locking means (580, 582) and a switching means that switches on the power source of the cartridge (503) when the locking means is locked.

19. The cartridge of claim 2 adapted to be used with an electronic device (1A, 1B) which is further equipped with a connector (CN11) connected to at least the address signal line of the first processor (510), wherein the cartridge (503) is further equipped with data fetch means that fetches data reflected in the address from an address signal output from the electronic device.

20. The cartridge of claim 2 adapted to be used with an electronic device (1A, 1B) which is further equipped with a first memory means that stores the processing executed by the first processor (510), a connector (CN11) connected to at least the address signal line of the first processor (510) and an address output means that reflects the data to be transferred to the outside in an address signal and outputs the address signal via the connector, wherein the cartridge (503) is further equipped with second memory means that stores the procedures executed by the second processor (601), data fetch means that fetches data reflected in the address from the address signal output from the electronic device, a circuit board (550) on which are mounted the second processor, the second memory means and the data fetch means, and grounding means (122) that electrically connects a conductive member of the electronic device, the power source wiring on the circuit board and the shielding member.

21. Electronic system equipped with an electronic device (1A, 1B) and a cartridge (503) according to any one of the preceding claims.

## Patentansprüche

1. Kassette für elektronische Vorrichtungen, die zum Einsetzen in eine vorgeschriebene Einschuböffnung einer elektronischen Vorrichtung (1A, 1B) geeignet ist, welche mit einem ersten Prozessor (510) ausgerüstet ist, der zu logischer Operation fähig ist, wobei die Kassette (503) mit einer Leiterplatte (550) ausgestattet ist, auf der die elektronischen Komponenten der Kassette angebracht sind und an der ein Stecker (551) zur elektrischen Verbindung mit der elektronischen Vorrichtung befestigt ist, einem Gehäuse (100, 120), welches die Leiterplatte beherbergt und ein Durchgangsloch (142) für den Durchgang des Steckers hat, und einem leitfähigen Abschirmglied; Verbindungseinrichtungen (104,122), die zur elektrischen Verbindung eines leitfähiges Gliedes der elektronischen Vorrichtung, der Stromquellenverdrahtung auf der Leiterplatte und dem Abschirmglied geeignet sind;
dadurch gekennzeichnet, daß ein mit dem Abschirmglied verbundener leitfähiger Teil (566) an mindestens einer Stelle des Durchgangslochs des Gehäuses (100, 120) nahe an der Mitte des Steckers (551) vorgesehen ist.

2. Kassette nach Anspruch 1, worin die Kassette (503) mit einem zweiten Prozessor (601) ausgestattet ist.

3. Kassette nach Anspruch 2, worin das Gehäuse (100, 120) das Abschirmglied enthält.

4. Kassette nach Anspruch 3, worin mindestens ein Teil des Gehäuses (100, 120) aus Metall besteht.

5. Kassette nach Anspruch 3, worin mindestens ein Teil des Gehäuses (100, 120) eine leitfähige Schicht besitzt.

6. Kassette nach Anspruch 3, worin das Gehäuse mit ersten und zweiten Gehäuseelementen (100, 120) ausgestattet ist, welche die Leiterplatte (550) beherbergen, und in dem Teil der Kassette (503), der aus der elektronischen Vorrichtung (1A, 1B) vorsteht, wenn die Kassette in der elektronischen Vorrichtung installiert ist, auf den zusammenpassenden Oberflächen jedes der ersten und zweiten Gehäuseelemente leitfähige Schichten ausgebildet sind.

7. Kassette nach Anspruch 6, worin eines der ersten und zweiten Gehäuseelemente (100, 120) aus Kunststoff und das andere aus Metall hergestellt ist.

8. Kassette nach einem der vorhergehenden Ansprüche, worin die Verbindungseinrichtung (104, 122) die Stromquellenverdrahtung auf der Leiterplatte (550) mit dem Abschirmglied an mehreren Stellen elektrisch verbindet.

9. Kassette nach Anspruch 3, worin die Verbindungseinrichtung (104, 122) mit einem am Abschirmglied befestigten leitfähigen elastischen Glied (122) ausgestattet ist und das leitfähige elastische Glied ein vorspringendes Glied (122B) hat, welches aus einer Öffnung in dem Gehäuse (100, 120) nach außen vorsteht und geeignet ist, mit einem leitfähigen Glied der elektronischen Vorrichtung (1A, 1B) elektrisch verbunden zu werden, wenn die Kassette (503) in die elektronische Vorrichtung eingesetzt wird.

10. Kassette nach Anspruch 9, worin die Kassette (503) mit mehreren leitfähigen elastischen Gliedern (122) ausgestattet ist und mindestens ein leitfähiges elastisches Glied geeignet ist, mit einem leitfähigen Glied der elektronischen Vorrichtung (1A, 1B) elektrisch verbunden zu werden, wenn die Kassette in die elektronische Vorrichtung eingesetzt wird.

11. Kassette nach Anspruch 10, worin die mehreren leitfähigen elastischen Glieder (122) das Abschirmglied und die Stromquellenverdrahtung auf der Leiterplatte (550) elektrisch verbinden.

12. Kassette nach Anspruch 7, worin die Kassette (503) mit einem Metallwärmeableitglied (110) ausgestattet ist, welches an dem Metallgehäuseelement (120) befestigt und im Innern des Gehäuses (100, 120) so angeordnet ist, daß es der Oberseite des zweiten Prozessors (601) gegenüberliegt, sowie einem Zwischenglied (102), welches zwischen dem Wärmeableitglied und der Oberseite des zweiten Prozessors angeordnet ist und mit dem Wärmeableitglied und dem zweiten Prozessor in Berührung steht.

13. Kassette nach Anspruch 12, worin die Kassette (503) mit einem elastischen Glied (126) ausgestattet ist, um den zweiten Prozessor (601) in Richtung zum Wärmeableitglied zu drücken.

14. Kassette nach Anspruch 3, worin die Leiterplatte (550) mit einem Verbinder (219) für einen Erweiterungsspeicher (200) ausgestattet ist.

15. Kassette nach Anspruch 14, worin das Gehäuse (100, 120) einen Erweiterungsschlitz (106) zum Einschub des Erweiterungsspeichers (200) in den Verbinder (210) zur Erweiterungsspeicherung und einen abnehmbaren Erweiterungsschlitzdeckel (150) hat, und der Erweiterungsschlitzdeckel in einer Stellung angeordnet ist, die im Innern der elektronischen Vorrichtung (1A, 1B) versteckt ist, wenn die Kassette (503) in die elektronische Vorrichtung eingesetzt ist.

16. Kassette nach Anspruch 15, worin der Erweiterungsspeicher (200) als IC-Karte gestaltet ist.

17. Kassette nach Anspruch 1, worin die Kassette (503) mit einer Kuppeleinrichtung ausgestattet ist, welche die hauptsächliche elektronische Vorrichtungseinheit (1A, 1B) und die Kassette (503) für elektronische Vorrichtungen mechanisch kuppelt.

18. Kassette nach Anspruch 17, worin die Kuppeleinrichtung mit einer Verriegelungseinrichtung (580, 582) und einer Schaltereinrichtung versehen ist, die die Stromquelle der Kassette (503) einschaltet, wenn die Verriegelungseinrichtung abgeschlossen wird.

19. Kassette nach Anspruch 2, die zur Verwendung mit einer elektronischen Vorrichtung (1A, 1B) angepaßt und ferner ausgestattet ist mit einem Verbinder (CN11), der mit mindestens der Adressensignalleitung des ersten Prozessors (510) verbunden ist, worin die Kassette (503) ferner mit einer Datenabrufeinrichtung ausgestattet ist, die in der Adresse reflektierte Daten von einem von der elektronischen Vorrichtung ausgegebenen Adressensignal abruft.

20. Kassette nach Anspruch 2, die zur Verwendung mit einer elektronischen Vorrichtung (1A, 1B) angepaßt und ferner mit einer ersten Speichereinrichtung ausgestattet ist, die die vom ersten Prozessor (510) ausgeführte Verarbeitung speichert, einem Verbinder (CN11), der mit mindestens der Adressensignalleitung des ersten Prozessors (510) verbunden ist, und einer Adressenausgabeeinrichtung, welche die nach außen zu übertragenden Daten in einem Adressensignal reflektiert und das Adressensignal über den Verbinder ausgibt, worin die Kassette (503) ferner mit einer zweiten Speichereinrichtung ausgestattet ist, die das vom zweiten Prozessor (601) gespeicherte Verfahren ausführt, einer Datenabrufeinrichtung, die in der Adresse reflektierte Daten aus dem von der elektronischen Vorrichtung ausgegebenen Adressensignal abruft, einer Leiterplatte (550), auf der der zweite Prozessor, die zweite Speichereinrichtung und die Datenabrufeinrichtung angebracht sind, und einer Erdungseinrichtung (122), die ein leitfähiges Glied der elektronischen Vorrichtung, die Stromversorgungsverdrahtung auf der Leiterplatte und das Abschirmglied elektrisch verbindet.

21. Elektronisches System, ausgestattet mit einer elektronischen Vorrichtung (1A, 1B) und einer Kassette (503) gemäß einem der vorhergehenden Ansprüche.

## Revendications

1. Cartouche pour dispositifs électriques agencée pour être insérée dans une ouverture d'insertion prescrite d'un dispositif (1A, 1B) électronique équipé d'un premier processeur (510) capable d'effectuer des opérations logiques, la cartouche (503) étant équipée d'une carte de circuit (550) sur laquelle sont montés les composants électriques contenus dans la cartouche et à laquelle est fixée une prise (551) de connexion électrique au dispositif électronique, un boîtier (100, 120) qui abrite la carte de circuit et comporte un trou traversant (142) par lequel passe la prise, et un élément de blindage conducteur ; un moyen (104, 122) de connexion agencé pour être apte à connecter électriquement un élément conducteur du dispositif électronique, le câblage de la source d'alimentation électrique se trouvant sur la carte de circuit et l'élément de blindage ;
caractérisé en ce qu'une partie (566) conductrice connectée à l'élément de blindage est prévue en au moins un emplacement du trou traversant du boîtier (100, 120) à proximité du milieu de la prise (551).

2. Cartouche suivant la revendication 1, dans laquelle la cartouche (503) est équipée d'un second processeur (601).

3. Cartouche suivant la revendication 2, dans laquelle le boîtier (100, 120) comporte un élément de blindage.

4. Cartouche suivant la revendication 3, dans laquelle au moins une partie du boîtier (100, 120) est faite de métal.

5. Cartouche suivant la revendication 3, dans laquelle au moins une partie du boîtier (100, 120) a une couche conductrice.

6. Cartouche suivant la revendication 3, dans laquelle le boîtier est équipé de premier et second éléments (100, 120) de boîtier qui abritent la carte (550) de circuit, et la partie de la cartouche (503) dépassant du dispositif (1A, 1B) électronique lorsque la cartouche est montée dans le dispositif électronique, comporte des couches conductrices formées sur les surfaces s'emboîtant mutuellement de chacun des premier et second éléments de boîtier.

7. Cartouche suivant la revendication 6, dans laquelle l'un des premier et second éléments (100, 120) de boîtier est fait de matière plastique et l'autre est fait de métal.

8. Cartouche suivant l'une quelconque des revendications précédentes, dans laquelle le moyen (104, 122) de connexion connecte électriquement le câblage de la source d'alimentation électrique se trouvant sur la carte (550) de circuit à l'élément de blindage en des emplacements multiples.

9. Cartouche suivant la revendication 3, dans laquelle le moyen (104, 122) de connexion est équipé d'un élément (122) élastique conducteur fixé à l'élément de blindage, et l'élément élastique conducteur comporte un élément (122B) faisant saillie qui dépasse vers l'extérieur d'une ouverture pratiquée dans le boîtier (100, 120) et est agencée pour être connecté électriquement à un élément conducteur du dispositif (1A, 1B) électronique lorsque la cartouche (503) est insérée dans le dispositif électronique.

10. Cartouche suivant la revendication 9, dans laquelle la cartouche (503) est équipée d'éléments (122) élastiques conducteurs multiples et au moins un élément élastique conducteur est agencé pour être connecté électriquement à un élément conducteur du dispositif (1A, 1B) électronique lorsque la cartouche est insérée dans le dispositif électronique.

11. Cartouche suivant la revendication 10, dans laquelle les éléments (122) élastiques conducteurs multiples connectent électriquement l'élément de blindage au câblage de la source d'alimentation se trouvant sur la carte (550) de circuit.

12. Cartouche suivant la revendication 7, dans laquelle la cartouche (503) est équipée d'un élément (110) métallique de dissipation thermique fixé à l'élément (120) de boîtier métallique et disposé à l'intérieur du boîtier (100, 120) de façon à être opposé à la surface supérieure du second processeur (601), et d'un élément (102) intermédiaire qui est disposé entre l'élément de dissipation thermique et la surface supérieure du second processeur et en contact avec l'élément de dissipation thermique et le second processeur.

13. Cartouche suivant la revendication 12, dans laquelle la cartouche (503) est équipée d'un élément (126) élastique pour repousser le second processeur (601) vers l'élément de dissipation thermique.

14. Cartouche suivant la revendication 3, dans laquelle la carte (550) de circuit est équipé d'un connecteur (219) pour une extension de mémoire (200).

15. Cartouche suivant la revendication 14, dans laquelle le boîtier (100, 120) comporte un créneau (106) d'extension destiné à l'insertion de l'extension de mémoire (200) dans le connecteur (210) d'extension de mémoire et un capuchon (150) amovible de créneau d'extension, et le capuchon de créneau d'extension est disposé en une position qui est dissimulée à l'intérieur du dispositif (1A, 1B) électronique lorsque la cartouche (503) est insérée dans le dispositif électronique

16. Cartouche suivant la revendication 15, dans laquelle l'extension de mémoire (200) présente la configuration d'une carte de circuit intégré.

17. Cartouche suivant la revendication 1, dans laquelle la cartouche (503) est équipée d'un moyen de jonction qui joint mécaniquement l'unité (1A, 1B) formant dispositif électronique principal à la cartouche (503) pour dispositifs électroniques.

18. Cartouche suivant la revendication 17 dans laquelle le moyen de jonction est muni d'un moyen (580, 582) de verrouillage et d'un moyen de commutation qui met sous tension la source d'alimentation électrique de la cartouche (503) lorsque le moyen de verrouillage est verrouillé.

19. Cartouche suivant la revendication 2, agencé pour être utilisée avec un dispositif (1A, 1B) électronique qui est en outre équipé d'un connecteur (CN11) connecté à au moins une ligne de signal d'adresse du premier processeur (510), la cartouche (503) étant en outre équipée d'un moyen de recherche de données qui recherche des données spécifiées dans l'adresse provenant d'une sortie de signal d'adresse du dispositif électronique.

20. Cartouche suivant la revendication 2, agencé pour être utilisée avec un dispositif (1A, 1B) électronique qui est en outre équipé d'un premier moyen à mémoire qui mémorise le traitement exécuté par le premier processeur (510), d'un connecteur (CN11) connecté à au moins la ligne de signal d'adresse du premier processeur (510) et d'un moyen de sortie d'adresse qui reflète les données devant être transférées vers l'extérieur dans un signal d'adresse et fournit en sortie le signal d'adresse par l'intermédiaire du connecteur, la cartouche (503) étant en outre équipée d'un second moyen à mémoire qui mémorise les procédures exécutées par le second processeur (601), d'un moyen de recherche de données qui recherche des données indiquées dans l'adresse provenant de la sortie du signal d'adresse du dispositif électronique, d'une carte (550) de circuit sur laquelle sont montés le second processeur, le second moyen à mémoire et le moyen de recherche de données, et d'un moyen (122) de mise à la masse qui connecte électriquement un élément conducteur du dispositif électronique, le câblage de la source d'alimentation se trouvant sur la carte de circuit et l'élément de blindage.

21. Système électronique équipé d'un dispositif (1A, 1B) électronique et d'une cartouche (503) suivant l'une quelconque des revendications précédentes.
